# EUROPEAN PATENT SPECIFICATION

(11) **EP 2 325 695 B1**
(45) Date of publication and mention of the grant of the patent: **20.12.2017**
(21) Application number: 09813111.3
(22) Date of filing: 10.09.2009
(51) Int. Cl.: G03F 7/039, C08F 20/26, G03F 7/004, C08F 20/28

(54) **RADIATION-SENSITIVE RESIN COMPOSITION**
STRAHLUNGSEMPFINDLICHE HARZZUSAMMENSETZUNG
COMPOSITION DE RÉSINE SENSIBLE AUX RAYONNEMENTS

(30) Priority: 10.09.2008 JP 2008232552; 08.01.2009 JP 2009002730; 08.01.2009 JP 2009002797
(43) Date of publication of application: 25.05.2011
(73) Proprietor: JSR Corporation, Tokyo 105-8640 (JP)
(72) Inventor: EBATA, Takuma, Tokyo 105-8640 (JP); NAKAGAWA, Hiroki, Tokyo 105-8640 (JP); MATSUDA, Yasuhiko, Tokyo 105-8640 (JP); KASAHARA, Kazuki, Tokyo 105-8640 (JP); HOSHIKO, Kenji, Tokyo 105-8640 (JP); NAKASHIMA, Hiromitsu, Tokyo 105-8640 (JP); IKEDA, Norihiko, Tokyo 105-8640 (JP); SAKAI, Kaori, Tokyo 105-8640 (JP); HARADA, Saki, Tokyo 105-8640 (JP)
(74) Representative: TBK
(86) International application number: PCT/JP2009/065819
(87) International publication number: WO 2010/029965

(56) References cited:
- EP-A1- 2 131 240
- WO-A1-2008/117693
- JP-A- 10 133 377
- JP-A- 2000 336 121
- JP-A- 2002 338 633
- JP-A- 2007 298 569
- JP-A- 2008 191 341
- US-A- 5 910 392
- US-B1- 6 280 898
- KOJI NOZAKI ET AL.: 'New Protective Groups in Alicyclic Methacrylate Polymers for 198-nm Resists' JOURNAL OF PHOTOPOLYMER SCIENCE AND TECHNOLOGY vol. 10, no. 4, 1997, pages 545 - 550, XP008144067

## Description

### TECHNICAL FIELD

The present invention relates to a radiation-sensitive resin composition that may be used for photolithography employed in the production of semiconductor devices (e.g., IC), liquid crystal devices, circuit boards (e.g., thermal head), and the like. More specifically, the invention relates to a chemically-amplified radiation-sensitive resin composition that may suitably be used for photolithography that utilizes deep ultraviolet rays having a wavelength of 250 nm or less (e.g., KrF excimer laser or ArF excimer laser), or electron beams, as an exposure light source.

### BACKGROUND ART

A chemically-amplified radiation-sensitive resin composition generates an acid upon exposure to deep ultraviolet rays having a wavelength of 250 nm or less (e.g., KrF excimer laser light or ArF excimer laser light) or electron beams. A difference in dissolution rate in a developer occurs between the exposed area and the unexposed area due to chemical reactions catalyzed by the acid, so that a resist pattern is formed on a substrate.

For example, when using a KrF excimer laser (wavelength: 248 nm) as a light source, a chemically-amplified radiation-sensitive resin composition that includes a polymer having a poly(hydroxystyrene) (PHS) basic skeleton that has a low absorbance at 248 nm has been used. An excellent pattern can be formed with high sensitivity and high resolution by utilizing such a composition.

However, when using a light source having a shorter wavelength (e.g., ArF excimer laser (wavelength: 193 nm)) in order to implement advanced micro fabrication, it is difficult to utilize an aromatic compound (e.g., PHS) that has a high absorbance at 193 nm.

Therefore, a resin composition that includes a polymer including an alicyclic hydrocarbon that does not have a high absorbance at 193 nm in its skeleton (particularly a polymer including a lactone skeleton in its repeating unit) has been used as a lithography material when using an ArF excimer laser as a light source.

For example, a radiation-sensitive resin composition that includes a polymer including a mevalonic lactone skeleton or a γ-butyrolactone skeleton in its repeating unit has been disclosed (see Patent Documents 1 and 2). A resin composition that includes a polymer including an alicyclic lactone skeleton in its repeating unit has also been disclosed (see Patent Documents 3 to 13).

EP2131240 (A1) (Art. 54(3) EPC) discloses a method of patterning using double exposure patterning in a liquid immersion lithographic process. According to the method, the pattern formed in the first layer is made inactive to radiation applied to when forming a second layer pattern, whereby it is possible to form the second layer pattern while maintaining the first layer pattern as is without making it soluble in alkali. The patterning method comprises a step of forming a first pattern on a substrate using a first resist layer forming composition, a step of making the first pattern inactive, a step of forming a second pattern on a substrate on which a pattern has been formed using a second resist layer forming composition and exposing the second resist layer to radiation, and a step of developing the exposed resist layer to form a second pattern in the space area of the first pattern. The first resist layer forming composition contains a cross-linking agent which accelerates conversion of the first layer from positive-working to negative-working.

US5910392 (A) discloses a chemically amplified resist composition that is able to form a resist pattern that can be exposed in short wavelength regions, has good transparency, sensitivity, dry-etch resistance and resolution, while also exhibiting excellent adhesion to the substrate. This chemically amplified resist composition comprises: the combination of a base resin comprised of a polymer that is itself insoluble in a basic aqueous solution and contains at least (A) a monomer unit I having carboxylic acid or phenol protected with a specific protective group, and (B) a monomer unit II having an ester group or ether group that contains a cyclic carbonate structure, and can become soluble in a basic aqueous solution when the protective group of the monomer unit I is deprotected by the effect of the acid; and, a photo acid generator capable of generating an acid that can provoke deprotection of the protective group of monomer unit I when decomposed by absorption of imaging radiation.

US6280898 (B1) describes a lactone-containing compound as well as a polymer comprising units of the compound. The polymer is used as a base resin to formulate a resist composition having a high sensitivity, resolution and etching resistance.

### RELATED-ART DOCUMENT

### PATENT DOCUMENT

Patent Document 1: Japanese Patent Application Publication (KOKAI) No. 9-73173
Patent Document 2: United States Patent No. 6,388,101
Patent Document 3: Japanese Patent Application Publication (KOKAI) No. 2000-159758
Patent Document 4: Japanese Patent Application Publication (KOKAI) No. 2001-109154
Patent Document 5: Japanese Patent Application Publication (KOKAI) No. 2004-101642
Patent Document 6: Japanese Patent Application Publication (KOKAI) No. 2003-113174
Patent Document 7: Japanese Patent Application Publication (KOKAI) No. 2003-147023
Patent Document 8: Japanese Patent Application Publication (KOKAI) No. 2002-308866
Patent Document 9: Japanese Patent Application Publication (KOKAI) No. 2002-371114
Patent Document 10: Japanese Patent Application Publication (KOKAI) No. 2003-64134
Patent Document 11: Japanese Patent Application Publication (KOKAI) No. 2003-270787
Patent Document 12: Japanese Patent Application Publication (KOKAI) No. 2000-26446
Patent Document 13: Japanese Patent Application Publication (KOKAI) No. 2000-122294

### DISCLOSURE OF THE INVENTION

The above compositions exhibit remarkably improved resolution when used as a resist due to a lactone skeleton included in the repeating unit. However, since the line width of a resist pattern has been reduced to 90 nm or less, performance other than high resolution has also been desired for resist compositions. For example, liquid immersion lithography has been put to practical use as fine resist pattern-forming technology, and a resist material that can deal with liquid immersion lithography has been desired. Specifically, development of a material that satisfies various requirements (e.g., depth of focus (DOF), line width roughness (LWR), mask error enhancement factor (MEEF), pattern collapse resistance, and development defect resistance) has been desired.

The invention was conceived in view of the above problems. An object of the invention is to provide a radiation-sensitive resin composition that exhibits a wide depth of focus, low LWR, a small MEEF, excellent pattern collapse resistance, and excellent development defect resistance.

The inventors of the invention conducted extensive studies in order to solve the above problems. As a result, the inventors found that the above problems can be solved by utilizing a polymer that includes a repeating unit including a cyclic carbonate structure, an acid diffusion controller that includes a carbamate structure, and the like as components of a radiation-sensitive resin composition. This finding has led to the completion of the invention. Specifically, the invention provides the following radiation-sensitive resin composition.
[1] A radiation-sensitive resin composition as defined by claim 1.
[2] Further beneficial radiation-sensitive resin compositions are defined in claims 2 and 3.
[4] A polymer as defined by claim 4.
[5] Further beneficial polymers are defined in claims 5 and 6.

The above radiation-sensitive resin composition exhibits a wide depth of focus, low LWR, a small MEEF, excellent pattern collapse resistance, and excellent development defect resistance. Therefore, the radiation-sensitive resin composition may suitably be used as a material for lithography that utilizes an ArF excimer laser as a light source. The radiation-sensitive resin composition may also be suitably used as a material for liquid immersion lithography or lithography that utilizes a KrF excimer laser as a light source.

### BRIEF DESCRIPTION OF THE DRAWINGS

FIG. 1 is a ¹³C-NMR analysis chart of a polymer (A-5) used for a radiation-sensitive resin composition.
FIG. 2 is a ¹³C-NMR analysis chart of a polymer (A-7) used for a radiation-sensitive resin composition according to one embodiment of the invention.

### DESCRIPTION OF EXEMPLARY EMBODIMENTS

Exemplary embodiments of the invention are described in detail below. Note that the invention is not limited to the following embodiments, but includes any possible embodiments that fall within the scope of the invention. In the following description, an identical substituent (group) is indicated by an identical symbol, and description thereof is omitted.

The term "group" used herein refers to a group that may be substituted. For example, the term "alkyl group" includes an unsubstituted alkyl group and an alkyl group in which a hydrogen atom is substituted with another functional group. The term "group" used herein refers to a group that may be branched. For example, the term "alkylcarbonyl group" includes a linear alkylcarbonyl group and a branched alkylcarbonyl group.

A radiation-sensitive resin composition according to one embodiment of the invention necessarily includes (A) a polymer, (B) an acid generator (photoacid generator), and (C) an acid diffusion controller (C), and optionally includes (D) a solvent and (E) an additive. Each component is described below.

### [1] Polymer (A)

The polymer (A) includes a repeating unit (a-1) shown by the general formula (a-1).

### [1-1] Repeating unit (a-1)

The repeating unit (a-1) shown by the general formula (a-1) includes a group that includes a cyclic carbonate structure (i.e., a group shown by the general formula (a')). The repeating unit (a-1) is an indispensable repeating unit of the polymer (A).

Examples of the repeating unit (a-1) include repeating units (a-1a), (a-1c) to (a-1l), and (a-1n) to (a-1q) shown by the following general formulas (a-1a), (a-1c) to (a-1l), and (a-1n) to (a-1q).

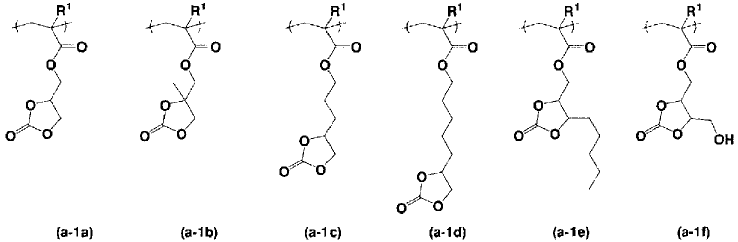

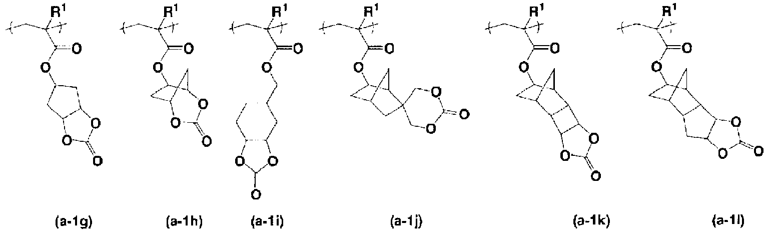

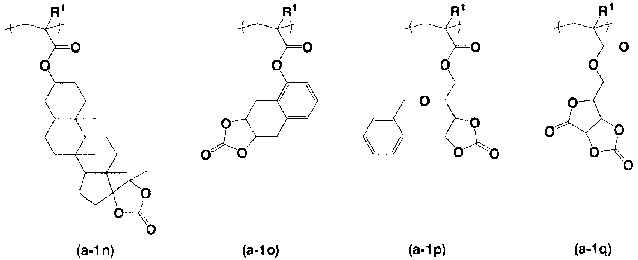

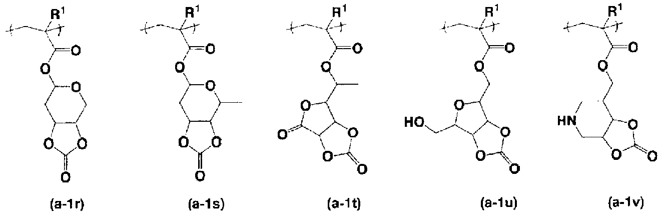

In the general formula (a-1), R¹ individually represent a hydrogen atom, a methyl group, or a trifluoromethyl group. Among these, a methyl group is preferable. R represents a monovalent group shown by the general formula (a'), and R¹⁹ individually represent a hydrogen atom or a chain-like hydrocarbon group having 1 to 5 carbon atoms. Examples of the chain-like hydrocarbon group having 1 to 5 carbon atoms include linear alkyl groups having 1 to 5 carbon atoms, such as a methyl group, an ethyl group, a propyl group, and a butyl group; branched alkyl groups having 3 to 5 carbon atoms, such as an isopropyl group, an isobutyl group, and a t-butyl group; and the like.

m and n in the general formula (a-1) are integers from 0 to 3 (m+n=1 to 3). Specifically, the cyclic carbonate has a five-membered ring structure when m+n=1, has a six-membered ring structure when m+n=2, and has a seven-membered ring structure when m+n=3. For example, the repeating unit (a-1a) has a five-membered ring structure, the repeating unit (a-1j) has a six-membered ring structure, and the repeating unit (a-1h) has a seven-membered ring structure.

In the general formula (a-1), A represents a single bond, a divalent chain-like hydrocarbon group having 1 to 30 carbon atoms, a divalent alicyclic hydrocarbon group having 3 to 30 carbon atoms, or a divalent aromatic hydrocarbon group having 6 to 30 carbon atoms.

When A is a single bond, (1) the oxygen atom of (meth)acrylic acid that forms the polymer is directly bonded to the carbon atom that forms the group shown by the general formula (a').

The term "chain-like hydrocarbon group" used herein refers to a hydrocarbon group that does not include a cyclic structure in the main chain, and includes only a chain-like structure. Examples of the divalent chain-like hydrocarbon group having 1 to 30 carbon atoms include linear alkylene groups such as a methylene group, an ethylene group, a 1,2-propylene group, a 1,3-propylene group, a tetramethylene group, a pentamethylene group, a hexamethylene group, a heptamethylene group, an octamethylene group, a nonamethylene group, a decamethylene group, an undecamethylene group, a dodecamethylene group, a tridecamethylene group, a tetradecamethylene group, a pentadecamethylene group, a hexadecamethylene group, a heptadecamethylene group, an octadecamethylene group, a nonadecamethylene group, and an icosylene group; branched alkylene groups such as a 1-methyl-1,3-propylene group, a 2-methyl-1,3-propylene group, a 2-methyl-1,2-propylene group, a 1-methyl-1,4-butylene group, a 2-methyl-1,4-butylene group, a methylidene group, an ethylidene group, a propylidene group, and a 2-propylidene group; and the like.

The term "alicyclic hydrocarbon group" used herein refers to a hydrocarbon group that includes only an alicyclic hydrocarbon structure as a ring structure, and does not include an aromatic ring structure. Note that the alicyclic hydrocarbon group need not necessarily be formed only of an alicyclic hydrocarbon structure, but may also include a chain-like structure.

Examples of the divalent alicyclic hydrocarbon group include monocyclic cycloalkylene groups having 3 to 10 carbon atoms, such as a 1,3-cyclobutylene group, a 1,3-cyclopentylene group, a 1,4-cyclohexylene group, and a 1,5-cyclooctylene group; polycyclic cycloalkylene groups such as a 1,4-norbornylene group, a 2,5-norbornylene group, a 1,5-admantylene group, and a 2,6-admantylene group; and the like.

The term "aromatic hydrocarbon group" used herein refers to a hydrocarbon group that includes an aromatic ring structure. Note that the aromatic hydrocarbon group need not necessarily be formed only of an aromatic ring structure, but may also include a chain structure or an alicyclic hydrocarbon structure.

Examples of the divalent aromatic hydrocarbon group include arylene groups such as a phenylene group, a tolylene group, a naphthylene group, a phenanthrylene group, and an anthrylene group, and the like.

Examples of the structure when A is the chain-like hydrocarbon group include a structure in which the oxygen atom of (meth)acrylic acid that forms the polymer is bonded to the carbon atom that forms the group shown by the general formula (a') via a linear alkyl group having 1 to 5 carbon atoms (repeating units (a-1a) to (a-1f)). This structure may include a cyclic structure as a substituent for A (repeating unit (a-1p)).

The cyclic carbonate shown by the general formula (a') may be bonded to A via a second bond in addition to a first bond shown by the general formula (a-1), and may form a ring structure including the first bond and the second bond.

More specifically, the polymer (A) included in the radiation-sensitive composition according to one embodiment of the invention preferably includes at least one repeating unit selected from a repeating unit in which a first carbon atom of the cyclic carbonate is bonded to A via the first bond, and a second carbon atom differing from the first carbon atom is bonded to A via the second bond, so that a condensed ring is formed to include the first carbon atom and the second carbon atom, and a repeating unit in which a first carbon atom of the cyclic carbonate is bonded to A via the first bond and the second bond, so that a spiro ring is formed to include the first carbon atom as a spiro atom.

Specifically, the cyclic carbonate and A may form a condensed ring or a spiro ring. The repeating units (a-1g), (a-1k), (a-1l), (a-1q), (a-1t), (a-1u), (a-1i), (a-1r), (a-1s), and (a-1v) are examples in which a condensed ring is formed. The repeating units (a-1j) and (a-1n) are examples in which a spiro ring is formed. The above condensed ring or spiro ring may be a hetero ring (repeating units (a-1q) to (a-1v)).

Examples of the structure when A is the alicyclic hydrocarbon group include a structure in which the oxygen atom of (meth)acrylic acid that forms the polymer is bonded to the carbon atom that forms the cyclic carbonate via a norbornylane group (repeating units (a-1k) and (a-1l)), and the like. The repeating units (a-1k) and (a-1l) are examples in which a condensed ring is formed by a carbon atom included in A and two carbon atoms that form the cyclic carbonate.

Examples of the structure when A is the aromatic hydrocarbon group include a structure in which the oxygen atom of (meth)acrylic acid that forms the polymer is bonded to the carbon atom that forms the cyclic carbonate via a benzylene group (repeating unit (a-1o)), and the like. The repeating unit (a-1o) is an example in which a first carbon atom of the cyclic carbonate is bonded to A via the first bond, a second carbon atom differing from the first carbon atom is bonded to A via the second bond, and a condensed ring is formed to include the first carbon atom and the second carbon atom.

The above monomer may be synthesized by the method disclosed in Tetrahedron Letters, Vol. 27, No. 32, p. 3741 (1986), Organic Letters, Vol. 4, No. 15, p. 2561 (2002), or the like.

The polymer (A) may include only one type of repeating unit (a-1), or may include two or more types of repeating unit (a-1). The content of the repeating unit (a-1) in the polymer (A) is preferably 5 to 80 mol%, more preferably 10 to 70 mol%, and particularly preferably 10 to 50 mol%, based on the total amount of repeating units included in the polymer (A). If the content of the repeating unit (a-1) is within the above range, the developability, low defectivity, low LWR, low PEB temperature dependence, and the like of the resulting resist can be improved. If the content of the repeating unit (a-1) is less than 5 mol%, the resulting resist may exhibit insufficient developability and insufficient low defectivity. If the content of the repeating unit (a-1) exceeds 80 mol%, the resulting resist may not exhibit high resolution, low LWR, and low PEB temperature dependence.

The term "low defectivity" means that defects rarely occur during a photolithography process. Examples of defects that may occur during a photolithography process include a watermark defect, a blob defect, a bubble defect, and the like. If such defects occur to a large extent when producing a device, the yield of the device may significantly decrease.

The term "watermark defect" refers to a phenomenon in which a droplet mark of an immersion liquid remains on a resist pattern. The term "blob defect" refers to a phenomenon in which a polymer dissolved in a developer precipitates due to rinsing, and re-adheres to a substrate. The term "bubble defect" refers to a phenomenon in which a change in optical path occurs during liquid immersion lithography due to bubbles contained in an immersion liquid, so that the desired pattern is not obtained.

### [1-2] Repeating unit (a-2)

The polymer (A) includes a repeating unit (a-2) including a lactone structure in addition to the repeating unit (a-1).

Examples of the repeating unit (a-2) include repeating units (a-2a) to (a-2p) shown by the following formulas (a-2a) to (a-2p). 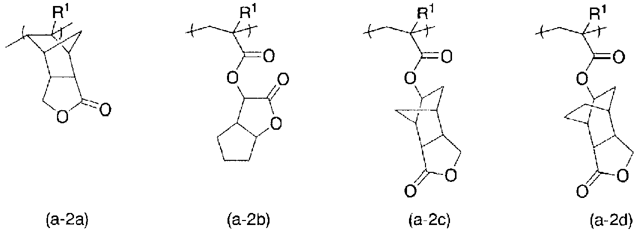 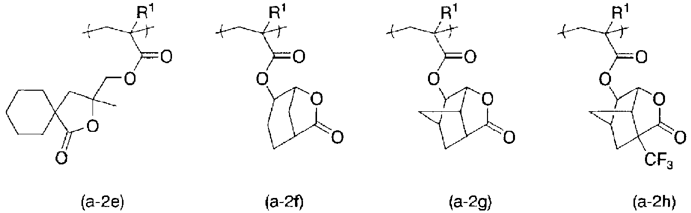 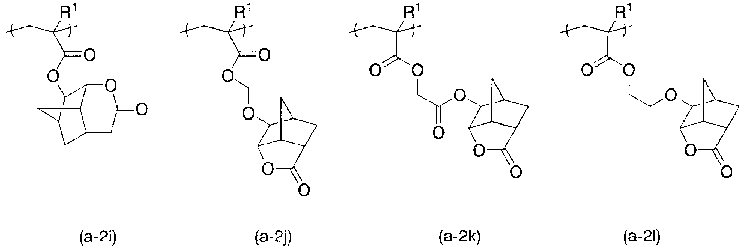 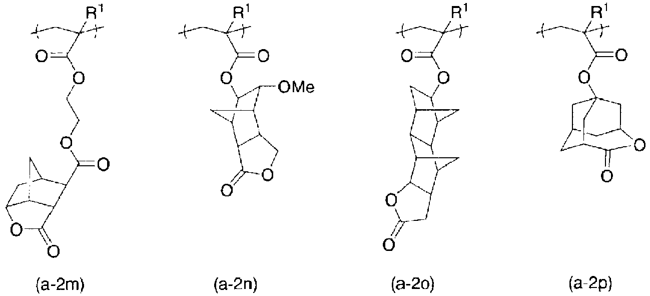 wherein R¹ represents a hydrogen atom, a methyl group, or a trifluoromethyl group.

The repeating unit (a-2) is preferably a repeating unit that includes a lactone ring condensed with an alicyclic hydrocarbon group. The repeating unit (a-2f) is an example of a repeating unit that includes a lactone ring condensed with a cyclohexane ring.

The repeating unit (a-2) is particularly preferably a repeating unit that includes a lactone ring condensed with a polyalicyclic hydrocarbon group. The repeating units (a-2a), (a-2c), and (a-2g) to (a-2o) are examples of a repeating unit that includes a lactone ring condensed with a norbornene ring, and the repeating unit (a-2d) is an example of a repeating unit that includes a lactone ring condensed with a bicyclo[2.2.2]octane ring.

Examples of a monomer that produces the repeating unit (a-2) include 5-oxo-4-oxatricyclo[4.2.1.0^{3,7}]non-2-yl (meth)acrylate, 9-methoxycarbonyl-5-oxo-4-oxatricyclo[4.2.1.0^{3,7}]non-2-yl (meth)acrylate, 5-oxo-4-oxatricyclo[5.2.1.0^{3,8}]dec-2-yl (meth)acrylate, 10-methoxycarbonyl-5-oxo-4-oxatricyclo[5.2.1.0^{3,8}]non-2-yl (meth)acrylate, 6-oxo-7-oxabicyclo[3.2.1]oct-2-yl (meth)acrylate, 4-methoxycarbonyl-6-oxo-7-oxabicyclo[3.2.1]oct-2-yl (meth)acrylate, 7-oxo-8-oxabicyclo[3.3.1]oct-2-yl (meth)acrylate, 4-methoxycarbonyl-7-oxo-8-oxabicyclo[3.3.1]oct-2-yl (meth)acrylate, 2-oxotetrahydropyran-4-yl (meth)acrylate, 4-methyl-2-oxotetrahydropyran-4-yl (meth)acrylate, 4-ethyl-2-oxotetrahydropyran-4-yl (meth)acrylate, 4-propyl-2-oxotetrahydropyran-4-yl (meth)acrylate, 5-oxotetrahydrofuran-3-yl (meth)acrylate, 2,2-dimethyl-5-oxotetrahydrofuran-3-yl (meth)acrylate, 4,4-dimethyl-5-oxotetrahydrofuran-3-yl (meth)acrylate, 2-oxotetrahydrofuran-3-yl (meth)acrylate, 4,4-dimethyl-2-oxotetrahydrofuran-3-yl (meth)acrylate, 5,5-dimethyl-2-oxotetrahydrofuran-3-yl (meth)acrylate, 2-oxotetrahydrofuran-3-yl (meth)acrylate, 5-oxotetrahydrofuran-2-ylmethyl (meth)acrylate, 3,3-dimethyl-5-oxotetrahydrofuran-2-ylmethyl (meth)acrylate, 4,4-dimethyl-5-oxotetrahydrofuran-2-ylmethyl (meth)acrylate, and the like.

The polymer (A) may include only one type of repeating unit (a-2), or may include two or more types of repeating units (a-2). The content of the repeating unit (a-2) in the polymer (A) is preferably 0 to 90 mol%, more preferably 0 to 80 mol%, and particularly preferably 0 to 70, based on the total amount of repeating units included in the polymer (A). If the content of the repeating unit (a-2) exceeds 90 mol%, the resulting resist may exhibit a deterioration in resolution, LWR, and PEB temperature dependence.

### [1-3] Repeating unit (a-3)

The polymer (A) preferably includes a repeating unit (a-3) shown by the following general formula (a-3) in addition to the repeating unit (a-1). 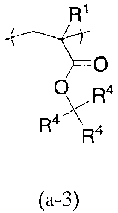 wherein R¹ individually represent a hydrogen atom, a methyl group, or a trifluoromethyl group, and R⁴ individually represent an alkyl group having 1 to 20 carbon atoms or an alicyclic hydrocarbon group having 3 to 20 carbon atoms, or two of R⁴ bond to form an alicyclic structure having 3 to 20 carbon atoms, and the remaining R⁴ represents an alkyl group having 1 to 10 carbon atoms.

Examples of an alkyl group having 1 to 20 carbon atoms represented by R⁴ in the general formulas (a-3) include linear alkyl groups such as a methyl group, an ethyl group, an n-propyl group, an n-butyl group, an n-hexyl group, a lauryl group, and a stearyl group; branched alkyl groups such as an i-propyl group, a 2-methylpropyl group, a 1-methylpropyl group, an isobutyl group, a t-butyl group, an isoamyl group, and a 2-ethylhexyl group; and the like. Examples of the alicyclic hydrocarbon group having 3 to 20 carbon atoms include cycloalkyl groups such as a cyclobutyl group, a cyclopentyl group, a cyclohexyl group, a cyclooctyl group, and a cyclododecyl group; polycyclic alicyclic hydrocarbon groups such as a bicyclo[2.2.1]heptyl group, a bicyclo[2.2.2]octyl group, a bicyclo[4.4.0]decyl group, a tricyclo[5.2.1.0^{2,6}]decyl group, a tetracyclo[6.2.1.1^{3,6}.0^{2,7}]dodecyl group, and a tricyclo[3.3.1.1^{3,7}]decyl group (adamantyl group); and the like. Examples of the alicyclic structure formed by two of R⁴ together with the carbon atom bonded thereto include an alicyclic structure (e.g., cycloalkane structure or polyalicyclic structure) that forms the above alicyclic hydrocarbon group, and the like.

The polymer (A) preferably includes at least one repeating unit selected from the repeating unit (a-3a) shown by the general formula (a-3a) and the repeating unit (a-3b) shown by the general formula (a-3b).

The repeating unit (a-3a) is preferably any of repeating units shown by the following general formulas (a-3a1) to (a-3a9).

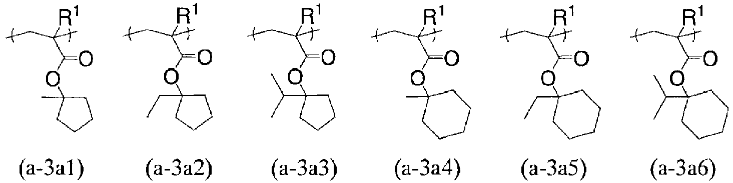

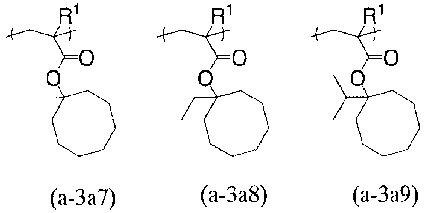

The repeating unit (a-3b) is preferably a repeating unit shown by the following general formula (a-3b1) or (a-3b2).

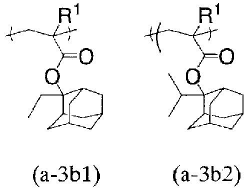

Examples of a preferable monomer that produces the repeating unit (a-3b) include 2-ethyladamant-2-yl (meth)acrylate, 2-ethyl-3-hydroxyadamant-2-yl (meth)acrylate, 2-n-propyladamant-2-yl (meth)acrylate, 2-isopropyladamant-2-yl (meth)acrylate, and the like. Among these, 2-ethyladamant-2-yl (meth)acrylate is preferable.

A polymer according to one embodiment of the invention includes a repeating unit (a-1) shown by the general formula (a-1), and at least one repeating unit selected from the repeating unit (a-3a) shown by the general formula (a-3a) and the repeating unit (a-3b) shown by the general formula (a-3b). It is preferable that the polymer according to one embodiment of the invention include the repeating unit (a-1) and the repeating unit (a-3a).

The polymer (A) may include only one type of repeating unit (a-3a) or repeating unit (a-3b), or may include two or more types of repeating unit (a-3a) (or (a-3b)). The content of the repeating units (a-3a) and (a-3b) in the polymer (A) is preferably 5 to 80 mol%, more preferably 10 to 80 mol%, and particularly preferably 20 to 70 mol%, based the total amount of repeating units included in the polymer (A). If the content of the repeating unit (a-3) exceeds 80 mol%, the resulting resist film may exhibit insufficient adhesion, so that the pattern may collapse, or may be removed.

Examples of the repeating unit (a-3) include repeating units shown by the following general formulas (a-3c) to (a-3i).

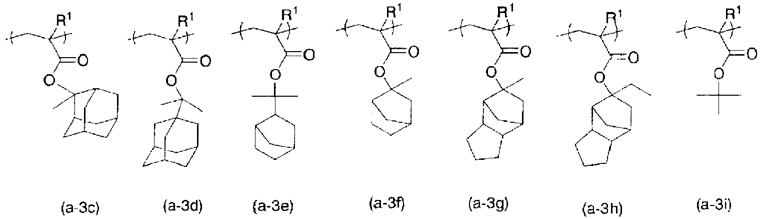

The polymer (A) may further include a repeating unit that includes an alkyl group or an alicyclic hydrocarbon group that includes at least one polar group as an additional repeating unit. A resist produced using a radiation-sensitive resin composition including such a polymer exhibits improved solubility in an alkaline developer (alkaline solution) when exposed.

Examples of the polar group include groups that are more polar than hydrocarbon groups, such as a hydroxyl group, a carboxyl group, a cyano group, an alkyl ester group, and an aromatic ester group. The polar group is preferably a group that includes a hydroxyl group (preferably a secondary or tertiary hydroxyl group), or a group that includes a carbonyl group, in order to reduce a residue upon development using an alkaline developer, and suppress development defects.

Examples of the additional repeating unit include repeating units shown by the following general formulas.

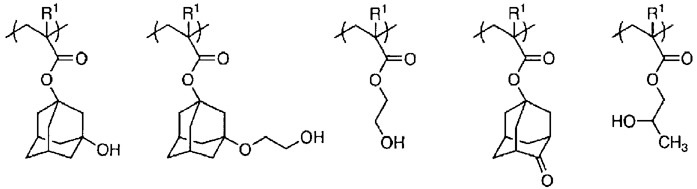

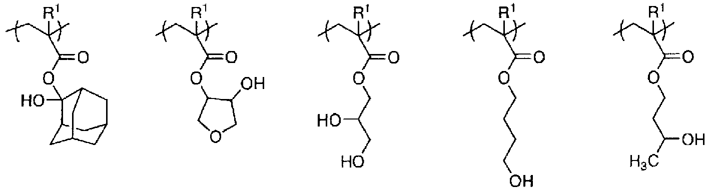

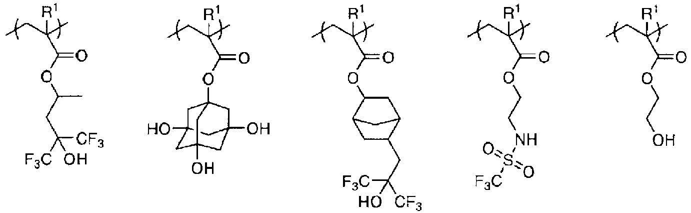

The polymer (A) may include a further additional repeating unit, such as a repeating unit derived from another (meth)acrylate.

### [1-4] Production method

A method of producing the polymer (A) is described below.

The polymer (A) may be synthesized by radical polymerization or the like. For example, the polymer (A) is preferably synthesized by (1) polymerizing a monomer while adding a solution containing a monomer and a radical initiator dropwise to a solution containing a reaction solvent or a monomer, (2) polymerizing a monomer while adding a solution containing a monomer and a solution containing a radical initiator dropwise to a solution containing a reaction solvent or a monomer, (3) polymerizing a monomer while adding a plurality of solutions containing different types of monomers and a solution containing a radical initiator dropwise to a solution containing a reaction solvent or a monomer, or the like.

The content of monomers in the monomer solution that is added dropwise to another monomer solution is preferably 30 mol% or more, more preferably 50 mol% or more, and particularly preferably 70 mol% or more, based on the total amount of monomers used for polymerization.

The reaction temperature may be appropriately determined depending on the type of initiator. The reaction temperature is normally 30 to 180°C, preferably 40 to 160°C, and more preferably 50 to 140°C. The addition time is determined depending on the reaction temperature, the type of initiator, the type of monomer, and the like, but is normally 30 minutes to 8 hours, preferably 45 minutes to 6 hours, and more preferably 1 to 5 hours. The total reaction time including the addition time is also determined depending on the reaction conditions, but is normally 30 minutes to 8 hours, preferably 45 minutes to 7 hours, and more preferably 1 to 6 hours.

Examples of the radical initiator used for polymerization include 2,2'-azobis(4-methoxy-2,4-dimethylvaleronitrile), 2,2'-azobis(2-cyclopropylpropionitrile), 2,2'-azobis(2,4-dimethylvaleronitrile), 2,2'-azobis-iso-butylonitrile, 2,2'-azobis(2-methylbutyronitrile), 1,1'-azobis(cyclohexane-1-carbonitrile), 2,2'-azobis(2-methyl-N-phenylpropioneamidine)dihydrochloride, 2,2'-azobis(2-methyl-N-2-propenylpropioneamidine)dihydrochloride, 2,2'-azobis[2-(5-methyl-2-imidazolin-2-yl)propane]dihydrochloride, 2,2'-azobis{2-methyl-N-[1,1-bis(hydroxymethyl)-2-hydroxyethyl]propioneamide}, dimethyl-2,2'-azobis(2-methylpropionate), 4,4'-azobis(4-cyanovaleric acid), 2,2'-azobis(2-(hydroxymethyl)propionitrile), and the like. These initiators may be used either individually or in combination.

A solvent that is other than a solvent that hinders polymerization (e.g., nitrobenzene having a polymerization inhibiting effect or a mercapto compound having a chain transfer effect) and dissolves the monomers may be used as the polymerization solvent. Examples of such a solvent include alcohols, ethers, ketones, amides, ester-lactones, nitriles, a mixture of these compounds, and the like.

Examples of the alcohols include methanol, ethanol, propanol, isopropanol, butanol, ethylene glycol, propylene glycol, ethylene glycol monomethyl ether, ethylene glycol monoethyl ether, 1-methoxy-2-propanol, and the like. Examples of the ethers include propyl ether, isopropyl ether, butyl methyl ether, tetrahydrofuran, 1,4-dioxane, 1,3-dioxolane, 1,3-dioxane, and the like.

Examples of the ketones include acetone, methyl ethyl ketone, diethyl ketone, methyl isopropyl ketone, methyl isobutyl ketone, and the like. Examples of the amides include N,N-dimethylformamide, N,N-dimethylacetamide, and the like. Examples of the ester-lactones include ethyl acetate, methyl acetate, isobutyl acetate, γ-butyrolactone, and the like. Examples of the nitriles include acetonitrile, propionitrile, butyronitrile, and the like. These solvents may be used either individually or in combination.

The polymer obtained by polymerization is preferably collected by re-precipitation. Specifically, the polymer solution is poured into a re-precipitation solvent after completion of polymerization to collect the target polymer as a powder. The above polymerization solvents may be used either individually or in combination as the re-precipitation solvent.

The content of low-molecular-weight components derived from monomers in the polymer (A) is preferably 0.1 mass% or less, more preferably 0.07 mass% or less, and particularly preferably 0.05 mass% or less, based on the total amount (100 mass%) of the polymer (A).

If the content of low-molecular-weight components is 0.1 mass% or less, it is possible to reduce the amount of eluate into water when performing liquid immersion lithography using a resist film produced using the polymer (A). It is also possible to prevent a situation in which foreign matter precipitates in the resist during storage, or uneven resist application occurs. This makes it possible to sufficiently suppress occurrence of defects when forming a resist pattern.

The term "low-molecular-weight components derived from monomers" used herein refers to components having a polystyrene-reduced weight average molecular weight (Mw) determined by gel permeation chromatography (GPC) of 500 or less. Examples of the low-molecular-weight components include monomers, dimers, trimers, oligomers, and the like. The low-molecular-weight components may be removed by chemical purification (e.g., washing with water or liquid-liquid extraction) or a combination of chemical purification and physical purification (e.g., ultrafiltration or centrifugation), for example.

The amount of low-molecular-weight components may be determined by analyzing the polymer (A) by high-performance liquid chromatography (HPLC). The content of impurities such as halogens and metals in the polymer (A) is preferably as low as possible. The sensitivity, the resolution, the process stability, the pattern shape, and the like of the resulting resist can be further improved by reducing the content of impurities.

The polystyrene-reduced weight average molecular weight (Mw) of the polymer (A) determined by gel permeation chromatography (GPC) is preferably 1000 to 100,000, more preferably 1000 to 3,000, and particularly preferably 1000 to 20,000. If the Mw of the polymer (A) is less than 1000, the heat resistance of the resulting resist may deteriorate. If the Mw of the polymer (A) exceeds 100,000, the developability of the resulting resist may deteriorate.

The ratio (Mw/Mn) of the Mw to the polystyrene-reduced number average molecular weight (Mn) of the polymer (A) determined by gel permeation chromatography (GPC) is normally 1.0 to 5.0, preferably 1.0 to 3.0, and more preferably 1.0 to 2.0.

The resin composition according to one embodiment of the invention may include only one type of polymer (A), or two or more types of polymer (A).

### [2] Acid generator (B)

The acid generator (B) is a photoacid generator that generates an acid upon exposure. The acid generator causes dissociation of an acid-dissociable group of the polymer (A) included in the radiation-sensitive resin composition (i.e., elimination of a protective group) due to an acid generated upon exposure, so that the polymer (A) becomes alkali-soluble. As a result, the exposed area of the resist film is readily dissolved in an alkaline developer, so that a positive-tone resist pattern is formed.

The acid generator (B) preferably includes a compound shown by the following general formula (B-1). 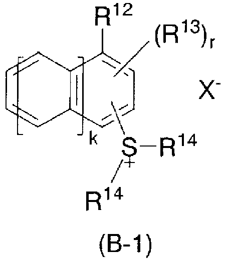 wherein R¹² represents a hydrogen atom, a fluorine atom, a hydroxyl group, an alkyl group having 1 to 10 carbon atoms, an alkoxy group having 1 to 10 carbon atoms, or an alkoxycarbonyl group having 2 to 11 carbon atoms, R¹³ represents an alkyl group having 1 to 10 carbon atoms, an alkoxy group having 1 to 10 carbon atoms, or an alkanesulfonyl group having 1 to 10 carbon atoms, and R¹⁴ individually represent an alkyl group having 1 to 10 carbon atoms, a phenyl group, or a naphthyl group, or bond to form a divalent group having 2 to 10 carbon atoms, k is an integer from 0 to 2, r is an integer from 0 to 10, and X⁻ represents an anion shown by any of the following general formulas (b-1) to (b-4).

R¹⁵C_{y}F_{2y}SO₃⁻ (b-1)

R¹⁵SO₃⁻ (b-2)

wherein R¹⁵ represents a hydrogen atom, a fluorine atom, or a hydrocarbon group having 1 to 12 carbon atoms, and y is an integer from 1 to 10. 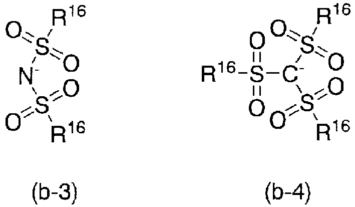 wherein R¹⁶ individually represent a fluoroalkyl group having 1 to 10 carbon atoms, provided that two R¹⁶ may bond to form a divalent fluoroalkylene group having 2 to 10 carbon atoms.

Examples of the alkyl group having 1 to 10 carbon atoms represented by R¹², R¹³, and R¹⁴ in the general formula (B-1) include the above alkyl groups having 1 to 4 carbon atoms, linear alkyl groups such as an n-pentyl group, an n-hexyl group, an n-heptyl group, an n-octyl group, an n-nonyl group, and an n-decyl group; branched alkyl groups such as a neopentyl group and a 2-ethylhexyl group; and the like. Among these, a methyl group, an ethyl group, an n-butyl group, a t-butyl group, and the like are preferable.

Examples of the alkoxy group having 1 to 10 carbon atoms represented by R¹² and R¹³ include linear alkoxy groups such as a methoxy group, an ethoxy group, an n-propoxy group, an n-butoxy group, an n-pentyloxy group, an n-hexyloxy group, an n-heptyloxy group, an n-octyloxy group, an n-nonyloxy group, and an n-decyloxy group; branched alkoxy groups such as an i-propoxy group, a 2-methylpropoxy group, a 1-methylpropoxy group, a t-butoxy group, a neopentyloxy group, and a 2-ethylhexyloxy group; and the like. Among these, a methoxy group, an ethoxy group, an n-propoxy group, an n-butoxy group, and the like are preferable.

Examples of the alkoxycarbonyl group having 2 to 11 carbon atoms represented by R¹² include linear alkoxycarbonyl groups such as a methoxycarbonyl group, an ethoxycarbonyl group, an n-propoxycarbonyl group, an n-butoxycarbonyl group, an n-pentyloxycarbonyl group, an n-hexyloxycarbonyl group, an n-heptyloxycarbonyl group, an n-octyloxycarbonyl group, an n-nonyloxycarbonyl group, and an n-decyloxycarbonyl group; branched alkoxycarbonyl groups such as an i-propoxycarbonyl group, a 2-methylpropoxycarbonyl group, a 1-methylpropoxycarbonyl group, a t-butoxycarbonyl group, a neopentyloxycarbonyl group, and a 2-ethylhexyloxycarbonyl group; and the like. Among these, a methoxycarbonyl group, an ethoxycarbonyl group, an n-butoxycarbonyl group, and the like are preferable.

Examples of the alkanesulfonyl group having 1 to 10 carbon atoms represented by R¹³ include linear alkanesulfonyl groups such as a methanesulfonyl group, an ethanesulfonyl group, an n-propanesulfonyl group, an n-butanesulfonyl group, an n-pentanesulfonyl group, an n-hexanesulfonyl group, an n-heptanesulfonyl group, an n-octanesulfonyl group, an n-nonanesulfonyl group, and an n-decanesulfonyl group; branched alkanesulfonyl groups such as a tert-butanesulfonyl group, a neopentanesulfonyl group, and a 2-ethylhexanesulfonyl group; cycloalkanesulfonyl groups such as a cyclopentanesulfonyl group and a cyclohexanesulfonyl group; and the like. Among these, a methanesulfonyl group, an ethanesulfonyl group, an n-propanesulfonyl group, an n-butanesulfonyl group, a cyclopentanesulfonyl group, a cyclohexanesulfonyl group, and the like are preferable.

r in the general formula (B-1) is preferably an integer from 0 to 2.

Examples of the phenyl group represented by R¹⁴ in the general formula (B-1) include a phenyl group, substituted phenyl groups such as an o-tolyl group, an m-tolyl group, a p-tolyl group, a 2,3-dimethylphenyl group, a 2,4-dimethylphenyl group, a 2,5-dimethylphenyl group, a 2,6-dimethylphenyl group, a 3,4-dimethylphenyl group, a 3,5-dimethylphenyl group, a 2,4,6-trimethylphenyl group, a 4-ethylphenyl group, a 4-t-butylphenyl group, a 4-cyclohexylphenyl group, and a 4-fluorophenyl group; groups obtained by substituting a hydrogen atom of these groups with at least one group selected from a hydroxyl group, a carboxyl group, a cyano group, a nitro group, an alkoxy group, an alkoxyalkyl group, an alkoxycarbonyl group, and an alkoxycarbonyloxy group; and the like.

Examples of the alkoxy group as a substituent for a phenyl group or a substituted phenyl group include linear alkoxy groups such as a methoxy group, an ethoxy group, an n-propoxy group, and an n-butoxy group; branched alkoxyl groups such as an i-propoxy group, a 2-methylpropoxy group, a 1-methylpropoxy group, and a t-butoxy group; cycloalkyloxy groups such as a cyclopentyloxy group and a cyclohexyloxy group; and the like. The number of carbon atoms of these groups is preferably 1 to 20.

Examples of the alkoxyalkyl group include linear alkoxyalkyl groups such as a methoxymethyl group, an ethoxymethyl group, a 2-methoxyethyl group, and a 2-ethoxyethyl group; branched alkoxyalkyl groups such as a 1-methoxyethyl group and a 1-ethoxyethyl group; alkoxyalkyl groups having a cycloalkane structure; and the like. The number of carbon atoms of these groups is preferably 1 to 20.

Examples of the alkoxycarbonyl group include linear alkoxycarbonyl groups such as a methoxycarbonyl group, an ethoxycarbonyl group, an n-propoxycarbonyl group, and n-butoxycarbonyl group; branched alkoxycarbonyl groups such as an i-propoxycarbonyl group, a 2-methylpropoxycarbonyl group, a 1-methylpropoxycarbonyl group, and a t-butoxycarbonyl group; cycloalkyloxycarbonyl groups such as a cyclopentyloxycarbonyl group and a cyclohexyloxycarbonyl group; and the like. The number of carbon atoms of these groups is preferably 2 to 21.

Examples of the alkoxycarbonyloxy group include linear alkoxycarbonyloxy groups such as a methoxycarbonyloxy group, an ethoxycarbonyloxy group, an n-propoxycarbonyloxy group, and an n-butoxycarbonyloxy group; branched alkoxycarbonyloxy groups such as an i-propoxycarbonyloxy group and a t-butoxycarbonyloxy group; cycloalkyloxycarbonyl groups such as a cyclopentyloxycarbonyl group and a cyclohexyloxycarbonyl group; and the like. The number of carbon atoms of these groups is preferably 2 to 21.

Examples of the phenyl group represented by R¹⁴ include a phenyl group, a 4-cyclohexylphenyl group, a 4-t-butylphenyl group, a 4-methoxyphenyl group, a 4-t-butoxyphenyl group, and the like.

Examples of the naphthyl group represented by R¹⁴ include a 1-naphthyl group, substituted naphthyl groups such as a 2-methyl-1-naphthyl group, a 3-methyl-1-naphthyl group, a 4-methyl-1-naphthyl group, a 5-methyl-1-naphthyl group, a 6-methyl-1-naphthyl group, a 7-methyl-1-naphthyl group, a 8-methyl-1-naphthyl group, a 2,3-dimethyl-1-naphthyl group, a 2,4-dimethyl-1-naphthyl group, a 2,5-dimethyl-1-naphthyl group, a 2,6-dimethyl-1-naphthyl group, a 2,7-dimethyl-1-naphthyl group, a 2,8-dimethyl-1-naphthyl group, a 3,4-dimethyl-1-naphthyl group, a 3,5-dimethyl-1-naphthyl group, a 3,6-dimethyl-1-naphthyl group, a 3,7-dimethyl-1-naphthyl group, a 3,8-dimethyl-1-naphthyl group, a 4,5-dimethyl-1-naphthyl group, a 5,8-dimethyl-1-naphthyl group, a 4-ethyl-1-naphthyl group, a 2-naphthyl group, a 1-methyl-2-naphthyl group, a 3-methyl-2-naphthyl group, and a 4-methyl-2-naphthyl group; groups obtained by substituting a hydrogen atom of these groups with at least one group selected from a hydroxyl group, a carboxyl group, a cyano group, a nitro group, an alkoxy group, an alkoxyalkyl group, an alkoxycarbonyl group, and an alkoxycarbonyloxy group; and the like.

Examples of the alkoxy group, the alkoxyalkyl group, the alkoxycarbonyl group, and the alkoxycarbonyloxy group that may substitute a hydrogen atom of a naphthyl group or the substituted naphthyl group include the groups mentioned above in connection with a phenyl group.

The naphthyl group represented by R¹⁴ is preferably a 1-naphthyl group, a 1-(4-methoxynaphthyl) group, a 1-(4-ethoxynaphthyl) group, a 1-(4-n-propoxynaphthyl) group, a 1-(4-n-butoxynaphthyl) group, a 2-(7-methoxynaphthyl) group, a 2-(7-ethoxynaphthyl) group, a 2-(7-n-propoxynaphthyl) group, a 2-(7-n-butoxynaphthyl) group, or the like.

The divalent group having 2 to 10 carbon atoms that includes two R¹⁴ is preferably a structure in which the two R¹⁴ bond to form a five or six-membered ring (particularly preferably a five-membered ring (i.e. tetrahydrothiophene ring)) together with the sulfur atom in the general formula (B-1).

A hydrogen atom of the divalent group may be substituted with at least one group selected from a hydroxyl group, a carboxyl group, a cyano group, a nitro group, an alkoxy group, an alkoxyalkyl group, an alkoxycarbonyl group, and an alkoxycarbonyloxy group. Some of the hydrogen atoms may be substituted. Examples of the alkoxy group, the alkoxyalkyl group, the alkoxycarbonyl group, and the alkoxycarbonyloxy group include the groups mentioned above in connection with a phenyl group.

It is preferable that R¹⁴ represent a methyl group, an ethyl group, a phenyl group, a 4-methoxyphenyl group, or a 1-naphthyl group, or two R¹⁴ bond to form a tetrahydrothiophene ring together with the sulfur atom in the general formula (B-1).

The cation in the general formula (B-1) is preferably a triphenylsulfonium cation, a tri-1-naphthylsulfonium cation, a tri-tert-butylphenylsulfonium cation, a 4-fluorophenyl-diphenylsulfonium cation, a di-4-fluorophenyl-phenylsulfonium cation, a tri-4-fluorophenylsulfonium cation, a 4-cyclohexylphenyl-diphenylsulfonium cation, a 4-methanesulfonylphenyl-diphenylsulfonium cation, a 4-cyclohexanesulfonyl-diphenylsulfonium cation, a 1-naphthyldimethylsulfonium cation, a 1-naphthyldiethylsulfonium cation, a 1-(4-hydroxynaphthyl)dimethylsulfonium cation, a 1-(4-methylnaphthyl)dimethylsulfonium cation, a 1-(4-methylnaphthyl)diethylsulfonium cation, a 1-(4-cyanonaphthyl)dimethylsulfonium cation, a 1-(4-cyanonaphthyl)diethylsulfonium cation, a 1-(3,5-dimethyl-4-hydroxyphenyl)tetrahydrothiophenium cation, a 1-(4-methoxynaphthyl)tetrahydrothiophenium cation, a 1-(4-ethoxynaphthyl)tetrahydrothiophenium cation, a 1-(4-n-propoxynaphthyl)tetrahydrothiophenium cation, a 1-(4-n-butoxynaphthyl)tetrahydrothiophenium cation, a 2-(7-methoxy naphthyl)tetrahydrothiophenium cation, a 2-(7-ethoxynaphthyl)tetrahydrothiophenium cation, a 2-(7-n-propoxynaphthyl)tetrahydrothiophenium cation, a 2-(7-n-butoxynaphthyl)tetrahydrothiophenium cation, or the like.

-C_{y}F_{2y}- in the general formula (b-1) represents a linear or branched perfluoroalkylene group having y carbon atoms. y is preferably 1, 2, 4, or 8.

The hydrocarbon group having 1 to 12 carbon atoms represented by R¹⁵ in the general formulas (b-1) and (b-2) is preferably an alkyl group, a cycloalkyl group, or a bridged alicyclic hydrocarbon group having 1 to 12 carbon atoms. Specific examples of the hydrocarbon group having 1 to 12 carbon atoms represented by R¹⁵ include a methyl group, an ethyl group, an n-propyl group, an i-propyl group, an n-butyl group, a 2-methylpropyl group, a 1-methylpropyl group, a t-butyl group, an n-pentyl group, an neopentyl group, an n-hexyl group, a cyclohexyl group, an n-heptyl group, an n-octyl group, a 2-ethylhexyl group, an n-nonyl group, an n-decyl group, a norbornyl group, a norbornylmethyl group, a hydroxynorbornyl group, an adamantyl group, and the like.

Examples of the fluoroalkyl group having 1 to 10 carbon atoms represented by R¹⁶ in the general formulas (b-3) and (b-4) include a trifluoromethyl group, a pentafluoroethyl group, a heptafuluoropropyl group, a nonafluorobutyl group, a dodecafluoropentyl group, a perfluorooctyl group, and the like.

Examples of the divalent fluoroalkylene group having 2 to 10 carbon atoms that includes two R¹⁶ include a tetrafluoroethylene group, a hexafluoropropylene group, an octafluorobutylene group, a decafluoropentylene group, an undecafluorohexylene group, and the like.

The anion moiety in the general formula (B-1) is preferably a trifluoromethanesulfonate anion, a perfluoro-n-butanesulfonate anion, a perfluoro-n-octanesulfonate anion, a 2-(bicyclo[2.2.1]hept-2-yl)-1,1,2,2-tetrafluoroethanesulfonate anion, a 2-(bicyclo[2.2.1]hept-2-yl)-1,1-difluoroethanesulfonate anion, a 1-adamantylsulfonate anion, an anion shown by any of the following formulas (b-3a) to (b-3g), or the like.

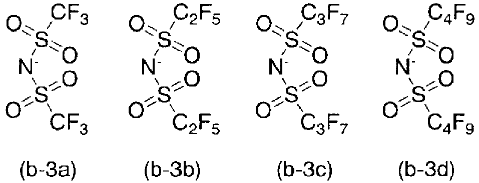

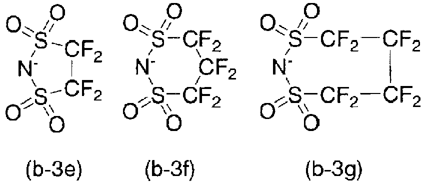

The acid generator (B) includes a combination of the above cation and anion. The combination is not particularly limited. The resin composition according to one embodiment of the invention may include only one type of acid generator (B), or may include two or more types of acid generator (B).

The resin composition according to one embodiment of the invention may also include an acid generator (i.e., additional acid generator) other than the acid generator (B). Examples of the additional acid generator include onium salt compounds, halogen-containing compounds, diazoketone compounds, sulfone compounds, sulfonic acid compounds, and the like. Specific examples of the additional acid generator are given below.

Examples of the onium salt compounds include an iodonium salt, a sulfonium salt, a phosphonium salt, a diazonium salt, a pyridinium salt, and the like. Specific examples of the onium salt compounds include diphenyliodonium trifluoromethanesulfonate, diphenyliodonium nonafluoro-n-butanesulfonate, diphenyliodonium perfluoro-n-octanesulfonate, diphenyliodonium 2-bicyclo[2.2.1]hept-2-yl-1,1,2,2-tetrafluoroethanesulfonate, bis(4-t-butylphenyl)iodonium trifluoromethanesulfonate, bis(4-t-butylphenyl)iodonium nonafluoro-n-butanesulfonate, bis(4-t-butylphenyl)iodonium perfluoro-n-octanesulfonate, bis(4-t-butylphenyl)iodonium 2-bicyclo[2.2.1]hept-2-yl-1,1,2,2-tetrafluoroethanesulfonate, cyclohexyl-2-oxocyclohexyl-methylsulfonium trifluoromethanesulfonate, dicyclohexyl-2-oxocyclohexylsulfonium trifluoromethanesulfonate, 2-oxocyclohexyldimethylsulfonium trifluoromethanesulfonate, and the like.

Examples of the halogen-containing compounds include haloalkyl group-containing hydrocarbon compounds, haloalkyl group-containing heterocyclic compounds, and the like. Specific examples of these halogen-containing compounds include (trichloromethyl)-s-triazine derivatives such as phenylbis(trichloromethyl)-s-triazine, 4-methoxyphenylbis(trichloromethyl)-s-triazine, and 1-naphthylbis(trichloromethyl)-s-triazine; 1,1-bis(4-chlorophenyl)-2,2,2-trichloroethane; and the like.

Examples of the diazoketone compounds include a 1,3-diketo-2-diazo compound, a diazobenzoquinone compound, a diazonaphthoquinone compound, and the like. Specific examples of these diazoketone compounds include 1,2-naphthoquinonediazide-4-sulfonyl chloride, 1,2-naphthoquinonediazide-5-sulfonyl chloride, 1,2-naphthoquinonediazide-4-sulfonate of 2,3,4,4'-tetrahydroxybenzophenone, 1,2-naphthoquinonediazide-5-sulfonate, 1,2-naphthoquinonediazide-4-sulfonate of 1,1,1-tris(4-hydroxyphenyl)ethane, 1,2-naphthoquinonediazide-5-sulfonate, and the like.

Examples of the sulfone compounds include β-ketosulfone, β-sulfonylsulfone, α-diazo compounds of these compounds, and the like. Specific examples of the sulfone compounds include 4-trisphenacylsulfone, mesitylphenacylsulfone, bis(phenylsulfonyl)methane, and the like.

Examples of the sulfonic acid compounds include alkyl sulfonates, alkylimide sulfonates, haloalkyl sulfonates, aryl sulfonates, imino sulfonates, and the like.

Specific examples of the sulfonic acid compounds include benzointosylate, tris(trifluoromethanesulfonate) of pyrogallol, nitrobenzyl-9,10-diethoxyanthracene-2-sulfonate, trifluoromethanesulfonylbicyclo[2.2.1]hept-5-ene-2,3-dicarbodiimide, nonafluoro-n-butanesulfonylbicyclo[2.2.1]hept-5-ene-2,3-dicarbodiimide, perfluoro-n-octanesulfonylbicyclo[2.2.1]hept-5-ene-2,3-dicarbodiimide, 2-bicyclo[2.2.1]hept-2-yl-1,1,2,2-tetrafluoroethanesulfonylbicyclo[2.2.1]hept-5-ene-2,3-dicarbodiimide, N-(trifluoromethanesulfonyloxy)succinimide, N-(nonafluoro-n-butanesulfonyloxy)succinimide, N-(perfluoro-n-octanelsulfonyloxy)succinimide, N-(2-bicyclo[2.2.1]hept-2-yl-1,1,2,2-tetrafluoroethanesulfonyloxy)succinimide, 1,8-naphthalenedicarboxylic acid imide trifluoromethanesulfonate, 1,8-naphthalenedicarboxylic acid imide nonafluoro-n-butanesulfonate, 1,8-naphthalenedicarboxylic acid imide perfluoro-n-octanesulfonate, and the like.

These acid generators may be used either individually or in combination.

The total amount of the acid generator (B) and the additional acid generator used in the resin composition according to one embodiment of the invention is normally 0.1 to 30 parts by mass, and preferably 0.5 to 20 parts by mass, based on 100 parts by mass of the polymer (A), so that the resulting resist exhibits sufficient sensitivity and developability. If the total amount of the acid generator (B) and the additional acid generator is less than 0.1 parts by mass, the sensitivity and the developability of the resist may decrease. If the total amount of the acid generator (B) and the additional acid generator exceeds 30 parts by mass, the radiation transmittance of the resulting resist may decrease, so that a rectangular resist pattern may not be obtained. The additional acid generator is preferably used in an amount of 80 mass% or less, and more preferably 60 mass% or less, based on the total amount of the acid generator (B) and the additional acid generator.

### [3] Acid diffusion controller (C)

The radiation-sensitive resin composition according to one embodiment of the invention further includes the acid diffusion controller (C) in addition to the polymer (A) and the acid generator (B). The acid diffusion controller (C) controls diffusion of an acid generated by the acid generator upon exposure within the resist film, and suppresses undesired chemical reactions in the unexposed area. The acid diffusion controller (C) improves the storage stability of the resulting radiation-sensitive resin composition, improves the resolution of the resulting resist, and suppresses a change in line width of the resist pattern due to a change in post-exposure delay (PED) from exposure to post-exposure bake. This enables a composition that exhibits excellent process stability to be obtained.

The radiation-sensitive resin composition according to one embodiment of the invention includes at least one base selected from (C-1) a base having a carbamate structure and (C-2) a photodegradable base.

### [3-1] Base (C-1)

The base (C-1) is shown by the following general formula (C-1). 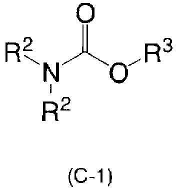 wherein R² and R³ individually represent a hydrogen atom, a monovalent chain-like hydrocarbon group having 1 to 20 carbon atoms, a monovalent alicyclic hydrocarbon group having 3 to 20 carbon atoms, or a monovalent aromatic hydrocarbon group having 6 to 20 carbon atoms, provided that the two R² may bond to form a ring structure.

The group represented by R³ in the general formula (C-1) is preferably a tert-butyl group or a tert-amyl group.

In the general formula (C-1), the two R² may bond to form a ring structure. For example, the nitrogen-containing compound (C-1) includes a compound in which the nitrogen atom in the general formula (C-1) forms part of a cyclic amine (e.g., N-t-butoxycarbonylpyrrolidine or N-t-butoxycarbonyl-2-phenylbenzimidazole).

Examples of the nitrogen-containing compound shown by the general formula (C-1) include N-t-butyl group-containing amino compounds such as N-t-butoxycarbonyl di-n-octylamine, N-t-butoxycarbonyl di-n-nonylamine, N-t-butoxycarbonyl di-n-decylamine, N-t-butoxycarbonyl dicyclohexylamine, N-t-butoxycarbonyl-1-adamantylamine, N-t-butoxycarbonyl-2-adamantylamine, N-t-butoxycarbonyl-N-methyl-1-adamantylamine, (S)-(-)-1-(t-butoxycarbonyl)-2-pyrrolidine methanol, (R)-(+)-1-(t-butoxycarbonyl)-2-pyrrolidine methanol, N-t-butoxycarbonyl-4-hydroxypiperidine, N-t-butoxycarbonylpyrrolidine, N,N'-di-t-butoxycarbonylpiperazine, N,N-di-t-butoxycarbonyl-1-adamantylamine, N,N-di-t-butoxycarbonyl-N-methyl-1-adamantylamine, N-t-butoxycarbonyl-4,4'-diaminodiphenylmethane, N,N'-di-t-butoxycarbonylhexamethylenediamine, N,N,N'N'-tetra-t-butoxycarbonylhexamethylenediamine, N,N'-di-t-butoxycarbonyl-1,7-diaminoheptane, N,N'-di-t-butoxycarbonyl-1,8-diaminonooctane, N,N'-di-t-butoxycarbonyl-1,9-diaminononane, N,N'-di-t-butoxycarbonyl-1,10-diaminodecane, N,N'-di-t-butoxycarbonyl-1,12-diaminododecane, N,N'-di-t-butoxycarbonyl-4,4'-diaminodiphenylmethane, N-t-butoxycarbonylbenzimidazole, N-t-butoxycarbonyl-2-methylbenzimidazole, and N-t-butoxycarbonyl-2-phenylbenzimidazole;
N-t-amyl group-containing amino compounds such as N-t-amyloxycarbonyl di-n-octylamine, N-t-amyloxycarbonyl di-n-nonylamine, N-t-amyloxycarbonyl di-n-decylamine, N-t-amyloxycarbonyl dicyclohexylamine, N-t-amyloxycarbonyl-1-adamantylamine, N-t-amyloxycarbonyl-2-adamantylamine, N-t-amyloxycarbonyl-N-methyl-1-adamantylamine, (S)-(-)-1-(t-amyloxycarbonyl)-2-pyrrolidine methanol, (R)-(+)-1-(t-amyloxycarbonyl)-2-pyrrolidine methanol, N-t-amyloxycarbonyl-4-hydroxypiperidine, N-t-amyloxycarbonylpyrrolidine, N,N'-di-t-amyloxycarbonylpiperazine, N,N-di-t-amyloxycarbonyl-1-adamantylamine, N,N-di-t-amyloxycarbonyl-N-methyl-1-adamantylamine, N-t-amyloxycarbonyl-4,4'-diaminodiphenylmethane, N,N'-di-t-amyloxycarbonylhexamethylenediamine, N,N,N'N'-tetra-t-amyloxycarbonylhexamethylenediamine, N,N'-di-t-amyloxycarbonyl-1,7-diaminoheptane, N,N'-di-t-amyloxycarbonyl-1,8-diaminonooctane, N,N'-di-t-amyloxycarbonyl-1,9-diaminononane, N,N'-di-t-amyloxycarbonyl-1,10-diaminodecane, N,N'-di-t-amyloxycarbonyl-1,12-diaminododecane, N,N'-di-t-amyloxycarbonyl-4,4'-diaminodiphenylmethane, N-t-amyloxycarbonylbenzimidazole, N-t-amyloxycarbonyl-2-methylbenzimidazole, and N-t-amyloxycarbonyl-2-phenylbenzimidazole; and the like.

Among these, N-t-butoxycarbonyl dicyclohexylamine, N-t-butoxycarbonyl-1-adamantylamine, N-t-butoxycarbonyl-2-adamantylamine, (S)-(-)-1-(t-butoxycarbonyl)-2-pyrrolidinemethanol, (R)-(+)-1-(t-butoxycarbonyl)-2-pyrrolidinemethanol, N-t-butoxycarbonylpyrrolidine, N-t-butoxycarbonyl-4-hydroxypiperidine, N-t-butoxycarbonyl-2-phenylbenzimidazole, N-t-amyloxycarbonyl dicyclohexylamine, N-t-amyloxycarbonyl-1-adamantylamine, N-t-amyloxycarbonyl-2-adamantylamine, (S)-(-)-1-(t-amyloxycarbonyl)-2-pyrrolidinemethanol, (R)-(+)-1-(t-amyloxycarbonyl)-2-pyrrolidinemethanol, N-t-amyloxycarbonylpyrrolidine, N-t-amyloxycarbonyl-4-hydroxypiperidine, and N-t-amyloxycarbonyl-2-phenylbenzimidazole are preferable, with N-t-butoxycarbonyldicyclohexylamine, (R)-(+)-1-(t-butoxycarbonyl)-2-pyrrolidinemethanol, N-t-butoxycarbonylpyrrolidine, N-t-butoxycarbonyl-4-hydroxypiperidine, and N-t-butoxycarbonyl-2-phenylbenzimidazole being more preferable.

### [3-2] Photodegradable base (C-2)

The term "photodegradable base" used herein refers to a salt shown by the following general formula (C-2). The photodegradable base is a compound that initially functions as a base, but decomposes upon exposure to active rays or radiation, and loses basicity. The photodegradable base decomposes in the exposed area, and loses acid diffusion controllability, so that an acid is diffused. On the other hand, the photodegradable base functions as a base (i.e., acid diffusion controller) in the unexposed area, and controls diffusion of an acid. This improves contrast between the exposed area and the unexposed area, so that the LWR properties, the pattern shape, and the pattern collapse resistance of the radiation-sensitive resin composition can be improved.

X⁺Z⁻ (C-2)

X⁺ in the general formula (C-2) represents a sulfonium cation or an iodonium cation. X⁺ preferably represents a sulfonium cation (c-2-1a) shown by the following general formula (c-2-1a) or an iodonium cation (c-2-1b) shown by the following general formula (c-2-1b). 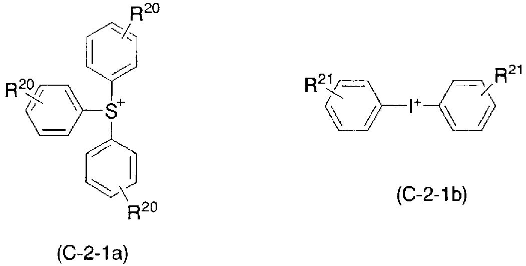 wherein R²⁰ and R²¹ individually represent a hydrogen atom, an alkyl group, an alkoxy group, a hydroxyl group, or a halogen atom.

The sulfonium cation (c-2-1a) is a triphenylsulfonium cation that may be substituted, and the iodonium cation (c-2-1b) is a diphenyliodonium cation that may be substituted.

The sulfonium cation (c-2-1a) is preferably a compound in which R²⁰ represents a hydrogen atom, an alkyl group, an alkoxy group, or a halogen atom, and the iodonium cation (c-2-1b) is preferably a compound in which R²¹ represents a hydrogen atom, an alkyl group, an alkoxy group, or a halogen atom. In this case, the solubility of the polymer (A) in a developer advantageously decreases.

Z⁻ in the general formula (C-2) represents an anion shown by OH⁻, R²¹-COO⁻, R²¹-SO₃⁻, or R²¹-N⁻-SO₂-R'. R²¹ and R' represent a substituted or unsubstituted alkyl group or a substituted or unsubstituted aryl group.

Examples of the substituted or unsubstituted alkyl group include unsubstituted alkyl groups, and alkyl groups including one or more substituents, such as a hydroxyalkyl group having 1 to 4 carbon atoms (e.g., hydroxymethyl group, 1-hydroxyethyl group, 2-hydroxyethyl group, 1-hydroxypropyl group, 2-hydroxypropyl group, 3-hydroxypropyl group, 1-hydroxybutyl group, 2-hydroxybutyl group, 3-hydroxybutyl group, and 4-hydroxybutyl group); an alkoxyl group having 1 to 4 carbon atoms (e.g., methoxy group, ethoxy group, n-propoxy group, i-propoxy group, n-butoxy group, 2-methylpropoxy group, 1-methylpropoxy group, and t-butoxy group); a cyano group; and a cyanoalkyl group having 2 to 5 carbon atoms (e.g., cyanomethyl group, 2-cyanoethyl group, 3-cyanopropyl group, and 4-cyanobutyl group). Among these, alkyl groups including a hydroxymethyl group, a cyano group, or a cyanomethyl group are preferable.

Examples of the substituted or unsubstituted aryl group include a phenyl group, a benzyl group, a phenylethyl group, a phenylpropyl group, a phenylcyclohexyl group, and groups obtained by substituting these groups with a hydroxyl group, a cyano group, or the like. Among these, a phenyl group, a benzyl group, and a phenylcyclohexyl group are preferable.

Z⁻ is preferably an anion shown by the following formula (C-2-2a), (C-2-2b), or (C-2-2c).

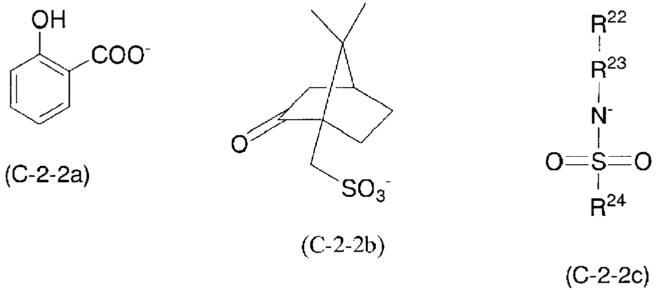

In the general formula (C-2-2c), R²² represents a hydrogen atom, a linear or branched monovalent hydrocarbon group having 1 to 10 carbon atoms for which some or all of the hydrogen atoms may be substituted with a fluorine atom, a hydroxyl group, an -OR", an -OCOR" group, or a -COOR" group, or a monovalent hydrocarbon group having 3 to 20 carbon atoms that has a cyclic structure or a partially cyclic structure, R²³ represents a single bond or a -O-(C=O)- group, R²⁴ represents a linear or branched monovalent hydrocarbon group having 1 to 10 carbon atoms for which some or all of the hydrogen atoms may be substituted with a fluorine atom, or a monovalent hydrocarbon group having 3 to 20 carbon atoms that has a cyclic structure or a partially cyclic structure, and R" represents a linear or branched monovalent hydrocarbon group having 1 to 10 carbon atoms or a monovalent hydrocarbon group having 3 to 20 carbon atoms that has a cyclic structure or a partially cyclic structure.

Specific examples of a compound that includes an anion shown by the general formula (C-2-2c) include compounds shown by the following formulas (i-1) to (i-25).

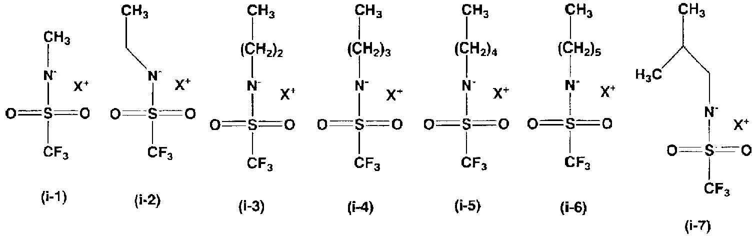

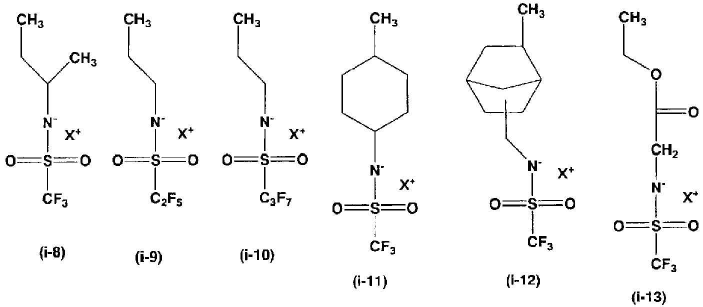

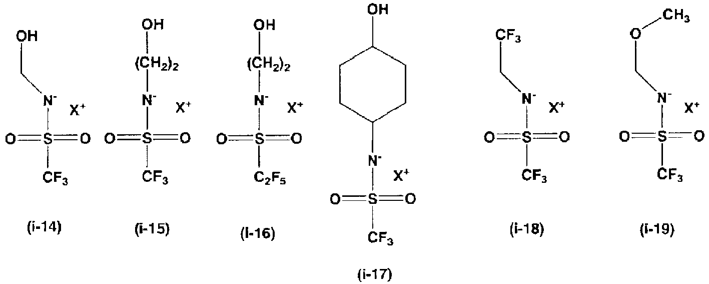

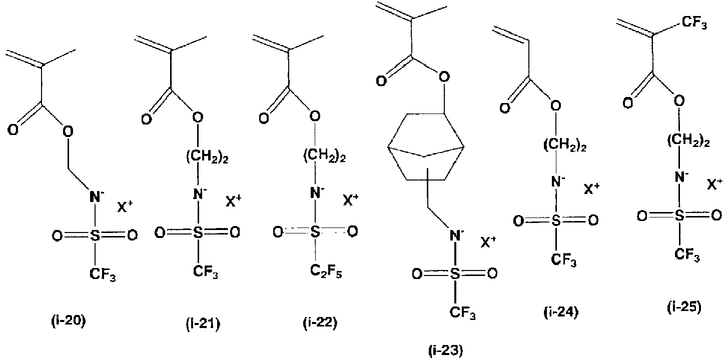

The compound (C-2) is a sulfonium salt compound or an iodonium salt compound that satisfies the above conditions.

Examples of the sulfonium salt compound include triphenylsulfonium hydroxide, triphenylsulfonium acetate, triphenylsulfonium salicylate, diphenyl-4-hydroxyphenylsulfonium hydroxide, diphenyl-4-hydroxyphenylsulfonium acetate, diphenyl-4-hydroxyphenylsulfonium salicylate, triphenylsulfonium 10-camphorsulfonate, 4-t-butoxyphenyldiphenylsulfonium 10-camphorsulfonate, and the like. These sulfonium salt compounds may be used either individually or in combination.

Examples of the iodonium salt compound include bis(4-t-butylphenyl)iodonium hydroxide, bis(4-t-butylphenyl)iodonium acetate, bis(4-t-butylphenyl)iodonium hydroxide, bis(4-t-butylphenyl)iodonium acetate, bis(4-t-butylphenyl)iodonium salicylate, 4-t-butylphenyl-4-hydroxyphenyliodonium hydroxide, 4-t-butylphenyl-4-hydroxyphenyliodonium acetate, 4-t-butylphenyl-4-hydroxyphenyliodonium salicylate, bis(4-t-butylphenyl)iodonium 10-camphorsulfonate, diphenyliodonium 10-camphorsulfonate, and the like. These iodonium salt compounds may be used either individually or in combination.

Examples of the acid diffusion controller (C) other than the base (C-1) and the photodegradable base (C-2) include nitrogen-containing compounds such as tertiary amine compounds, quaternary ammonium hydroxide compounds, and nitrogen-containing heterocyclic compounds.

Examples of the tertiary amine compounds include tri(cyclo)alkylamines such as triethylamine, tri-n-propylamine, tri-n-butylamine, tri-n-pentylamine, tri-n-hexylamine, tri-n-heptylamine, tri-n-octylamine, cyclohexyl dimethylamine, dicyclohexyl methylamine, and tricyclohexylamine; aromatic amines such as aniline, N-methylaniline, N,N-dimethylaniline, 2-methylaniline, 3-methylaniline, 4-methylaniline, 4-nitroaniline, 2,6-dimethylaniline, and 2,6-diisopropylaniline; alkanolamines such as triethanolamine and N,N-di(hydroxyethyl)aniline; N,N,N',N'-tetramethylethylenediamine, N,N,N',N'-tetrakis(2-hydroxypropyl)ethylenediamine, 1,3-bis[1-(4-aminophenyl)-1-methylethyl]benzene tetramethylenediamine, bis(2-dimethylaminoethyl)ether, bis(2-diethylaminoethyl)ether, and the like.

Examples of the quaternary ammonium hydroxide compounds include tetra-n-propylammonium hydroxide, tetra-n-butylammonium hydroxide, and the like.

Examples of the nitrogen-containing heterocyclic compounds include pyridines such as pyridine, 2-methylpyridine, 4-methylpyridine, 2-ethylpyridine, 4-ethylpyridine, 2-phenylpyridine, 4-phenylpyridine, 2-methyl-4-phenylpyridine, nicotine, nicotinic acid, nicotinamide, quinoline, 4-hydroxyquinoline, 8-oxyquinoline, and acridine; piperazines such as piperazine, 1-(2-hydroxyethyl)piperazine; pyrazine, pyrazole, pyridazine, quinoxaline, purine, pyrrolidine, piperidine, 3-piperidino-1,2-propanediol, morpholine, 4-methylmorpholine, 1,4-dimethylpiperazine, 1,4-diazabicyclo[2.2.2]octane, imidazole, 4-methylimidazole, 1-benzyl-2-methylimidazole, 4-methyl-2-phenylimidazole, benzimidazole, 2-phenylbenzimidazole, N-t-butoxycarbonylbenzimidazole, N-t-butoxycarbonyl-2-methylbenzimidazole, N-t-butoxycarbonyl-2-phenylbenzimidazole, and the like.

These acid diffusion controllers (C) may be used either individually or in combination.

The total amount of the acid diffusion controller (C) used in the resin composition according to one embodiment of the invention is preferably less than 10 parts by mass, and more preferably less than 5 parts by mass, based on 100 parts by mass of the polymer (A), so that the resulting resist exhibits high sensitivity. If the total amount of the acid diffusion controller (C) exceeds 10 parts by mass, the sensitivity of the resist may decrease to a large extent. Note that the pattern shape and the dimensional accuracy of the resist may deteriorate depending on the process conditions when the total amount of the acid diffusion controller (C) is less than 0.001 parts by mass.

### [4] Solvent (D)

The solvent (D) is not particularly limited insofar as the solvent (D) can dissolve the polymer (A), the acid generator (B), the acid diffusion controller (C), and the optional additive (E).

Examples of the solvent (D) include propylene glycol monoalkyl ether acetates such as propylene glycol monomethyl ether acetate, propylene glycol monoethyl ether acetate, propylene glycol mono-n-propyl ether acetate, propylene glycol mono-i-propyl ether acetate, propylene glycol mono-n-butyl ether acetate, propylene glycol mono-i-butyl ether acetate, propylene glycol mono-sec-butyl ether acetate, and propylene glycol mono-t-butyl ether acetate;
cyclic ketones such as cyclopentanone, 3-methylcyclopentanone, cyclohexanone, 2-methylcyclohexanone, 2,6-dimethylcyclohexanone, and isophorone; ketones such as 2-butanone, 2-pentanone, 3-methyl-2-butanone, 2-hexanone, 4-methyl-2-pentanone, 3-methyl-2-pentanone, 3,3-dimethyl-2-butanone, 2-heptanone, and 2-octanone; alkyl 2-hydroxypropionates such as methyl 2-hydroxypropionate, ethyl 2-hydroxypropionate, n-propyl 2-hydroxypropionate, i-propyl 2-hydroxypropionate, n-butyl 2-hydroxypropionate, i-butyl 2-hydroxypropionate, sec-butyl 2-hydroxypropionate, and t-butyl 2-hydroxypropionate; alkyl 3-alkoxypropionates such as methyl 3-methoxypropionate, ethyl 3-methoxypropionate, methyl 3-ethoxypropionate, and ethyl 3-ethoxypropionate;
n-propyl alcohol, i-propyl alcohol, n-butyl alcohol, t-butyl alcohol, cyclohexanol, ethylene glycol monomethyl ether, ethylene glycol monoethyl ether, ethylene glycol mono-n-propyl ether, ethylene glycol mono-n-butyl ether, diethylene glycol dimethyl ether, diethylene glycol diethyl ether, diethylene glycol di-n-propyl ether, diethylene glycol di-n-butyl ether, ethylene glycol monomethyl ether acetate, ethylene glycol monoethyl ether acetate, ethylene glycol mono-n-propyl ether acetate, propylene glycol monomethyl ether, propylene glycol monoethyl ether, propylene glycol mono-n-propyl ether,
toluene, xylene, ethyl 2-hydroxy-2-methylpropionate, ethyl ethoxyacetate, ethyl hydroxyacetate, methyl 2-hydroxy-3-methylbutyrate, 3-methoxybutyl acetate, 3-methyl-3-methoxybutyl acetate, 3-methyl-3-methoxybutyl propionate, 3-methyl-3-methoxybutyl butyrate, ethyl acetate, n-propyl acetate, n-butyl acetate, methyl acetoacetate, ethyl acetoacetate, methyl pyruvate, ethyl pyruvate, N-methylpyrrolidone, N,N-dimethylformamide, N,N-dimethylacetamide, benzyl ethyl ether, di-n-hexyl ether, diethylene glycol monomethyl ether, diethylene glycol monoethyl ether, caproic acid, caprylic acid, 1-octanol, 1-nonanol, benzyl alcohol, benzyl acetate, ethyl benzoate, diethyl oxalate, diethyl maleate, γ-butyrolactone, ethylene carbonate, propylene carbonate, and the like.

Among these, a propylene glycol monoalkyl ether acetate (particularly propylene glycol monomethyl ether acetate) is preferably used. It is also preferable to use a ketone, an alkyl 2-hydroxypropionate, an alkyl 3-alkoxypropionate, γ-butyrolactone, or the like. These solvents may be used either individually or in combination.

### [5] Additive (E)

The radiation-sensitive resin composition according to one embodiment of the invention may optionally include additive (E) such as a fluorine-containing polymer, an alicyclic skeleton-containing polymer, a surfactant, and a sensitizer. The content of each additive may be appropriately determined depending on the application.

The fluorine-containing polymer provides water repellency to the surface of the resist film during liquid immersion lithography. The fluorine-containing polymer suppresses elution of components from the resist film into an immersion liquid, or suppresses defects (e.g., watermark defect) due to liquid immersion lithography even if a high-speed scan is performed for liquid immersion lithography.

The structure of the fluorine-containing polymer is not particularly limited. Examples of the fluorine-containing polymer include (1) a fluorine-containing polymer that is insoluble in a developer, but becomes alkali-soluble due to an acid, (2) a fluorine-containing polymer that is soluble in a developer, and becomes more alkali-soluble due to an acid, (3) a fluorine-containing polymer that is insoluble in a developer, and becomes alkali-soluble due to an alkali, (4) a fluorine-containing polymer that is soluble in a developer, and becomes more alkali-soluble due to an alkali, and the like.

Specific examples of the fluorine-containing polymer include a polymer that includes at least one repeating unit selected from the repeating unit (a-3) and a fluorine-containing repeating unit. The fluorine-containing polymer preferably further includes the repeating unit (a-2).

Examples of the fluorine-containing repeating unit include trifluoromethyl (meth)acrylate, 2,2,2-trifluoroethyl (meth)acrylate, perfluoroethyl (meth)acrylate, perfluoro-n-propyl (meth)acrylate, perfluoro-i-propyl (meth)acrylate, perfluoro-n-butyl (meth)acrylate, perfluoro-i-butyl (meth)acrylate, perfluoro-t-butyl (meth)acrylate, perfluorocyclohexyl (meth)acrylate, 2-(1,1,1,3,3,3-hexafluoro)propyl (meth)acrylate, 1-(2,2,3,3,4,4,5,5-octafluoro)pentyl (meth)acrylate, 1-(2,2,3,3,4,4,5,5-octafluoro)hexyl (meth)acrylate, Perfluorocyclohexylmethyl (meth)acrylate, 1-(2, 2,3,3,3-pentafluoro)propyl (meth)acrylate, 1-(2,2,3,3,4,4,4-heptafluoro)penta (meth)acrylate, 1-(3,3,4,4,5,5,6,6,7,7, 8,8, 9,9,10,10,10-heptadecafluoro)decyl (meth)acrylate, 1-(5-trifluoromethyl-3,3,4,4,5,6,6,6-octafluoro)hexyl (meth)acrylate, and the like.

The fluorine-containing polymer is preferably a polymer shown by any of the following general formulas (E-1a) to (E-1f). These fluorine-containing polymers may be used either individually or in combination.

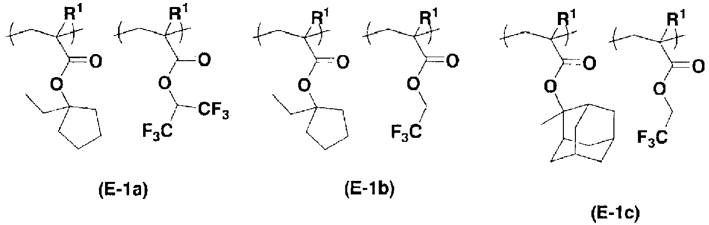

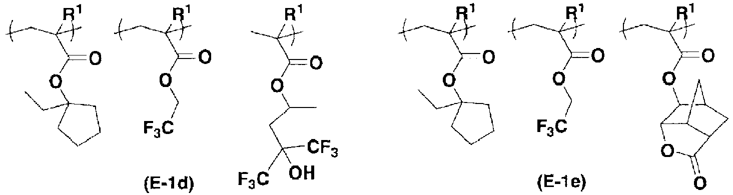

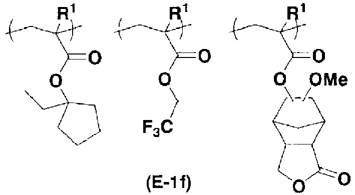

The alicyclic skeleton-containing polymer is a component that further improves the dry etching resistance, the pattern shape, adhesion to a substrate, and the like.

Examples of the alicyclic skeleton-containing polymer include adamantane derivatives such as 1-adamantanecarboxylate, 2-adamantanone, t-butyl 1-adamantanecarboxylate, t-butoxycarbonylmethyl 1-adamantanecarboxylate, α-butyrolactone 1-adamantanecarboxylate, di-t-butyl 1,3-adamantanedicarboxylate, t-butyl-1 adamantaneacetate, t-butoxycarbonylmethyl 1-adamantaneacetate, di-t-butyl 1,3-adamantanediacetate, and 2,5-dimethyl-2,5-di(adamantylcarbonyloxy)hexane;
deoxycholates such as t-butyl deoxycholate, t-butoxycarbonylmethyl deoxycholate, 2-ethoxyethyl deoxycholate, 2-cyclohexyloxyethyl deoxycholate, 3-oxocyclohexyl deoxycholate, tetrahydropyranyl deoxycholate, and mevalonolactone deoxycholate; lithocholates such as t-butyl lithocholate, t-butoxycarbonylmethyl lithocholate, 2-ethoxyethyl lithocholate, 2-cyclohexyloxyethyl lithocholate, 3-oxocyclohexyl lithocholate, tetrahydropyranyl lithocholate, and mevalonolactone lithocholate; alkyl carboxylates such as dimethyl adipate, diethyl adipate, dipropyl adipate, di-n-butyl adipate, and di-t-butyl adipate;
3-[2-hydroxy-2,2-bis(trifluoromethyl)ethyl]tetracyclo[4.4.0.1^{2,5}.1^{7,10}]dodecane, 2-hydroxy-9-methoxycarbonyl-5-oxo-4-oxa-tricyclo[4.2.1.0^{3,7}]nonane; and the like. These alicyclic skeleton-containing polymers may be used either individually or in combination.

The surfactant improves the applicability, striation, developability, and the like. Examples of the surfactant include nonionic surfactants such as polyoxyethylene lauryl ether, polyoxyethylene stearyl ether, polyoxyethylene oleyl ether, polyoxyethylene n-octylphenyl ether, polyoxyethylene n-nonylphenyl ether, polyethylene glycol dilaurate, and polyethylene glycol distearate, commercially available products such as KP341 (manufactured by Shin-Etsu Chemical Co., Ltd.), Polyflow No. 75, Polyflow No. 95 (manufactured by Kyoeisha Chemical Co., Ltd.), EFTOP EF301, EFTOP EF303, EFTOP EF352 (manufactured by JEMCO, Inc.), Megafac F171, Megafac F173 (manufactured by Dainippon Ink and Chemicals, Inc.), Fluorad FC430, Fluorad FC431 (manufactured by Sumitomo 3M Ltd.), Asahi GuardAG710, Surflon S-382, Surflon SC-101, Surflon SC-102, Surflon SC-103, Surflon SC-104, Surflon SC-105, Surflon SC-106 (manufactured by Asahi Glass Co., Ltd.), and the like. These surfactants may be used either individually or in combination.

The sensitizer absorbs the energy of radiation, and transmits the energy to the acid generator (B) so that the amount of acid generated increases. The sensitizer thus improves the apparent sensitivity of the radiation-sensitive resin composition.

Examples of the sensitizer include carbazoles, acetophenones, benzophenones, naphthalenes, phenols, biacetyl, eosine, rose bengal, pyrenes, anthracenes, phenothiazines, and the like. These sensitizers may be used either individually or in combination.

A dye, a pigment, an adhesion improver, or the like may also be used as the additive (E). For example, a dye or a pigment visualizes the latent image in the exposed area, so that the effect of halation during exposure can be reduced. An adhesion improver improves adhesion to a substrate. Examples of other additives include an alkali-soluble polymer, a low-molecular-weight alkali solubility controller containing an acid-dissociable protecting group, a halation inhibitor, a preservation stabilizer, an antifoaming agent, and the like.

These additives (E) may be used either individually or in combination.

### [6] Method of forming photoresist pattern

The radiation-sensitive resin composition according to one embodiment of the invention is useful as a chemically-amplified resist. When using the radiation-sensitive resin composition as a chemically-amplified resist, the acid-dissociable group of the polymer component (mainly the polymer (A)) dissociates due to an acid generated by the acid generator upon exposure to produce a carboxyl group. As a result, the solubility of the exposed area of the resist in an alkaline developer increases. Therefore, the exposed area is dissolved and removed by an alkaline developer to obtain a positive-tone photoresist pattern.

A photoresist pattern-forming method according to one embodiment of the invention includes (1) forming a photoresist film on a substrate using the above radiation-sensitive resin composition (hereinafter may be referred to as "step (1)"), (2) exposing the photoresist film (optionally via an immersion medium) by applying radiation to radiation via a mask having a given pattern (hereinafter may be referred to as "step (2)"), and (3) developing the exposed photoresist film to form a photoresist pattern (hereinafter may be referred to as "step (3)").

When employing liquid immersion lithography, a protective film that is insoluble in the immersion liquid may be formed on the resist film before the step (2) so that the immersion liquid does not directly come in contact with the resist film. A solvent removal-type protective film that is removed by a solvent prior to the step (3) (see Japanese Patent Application Publication (KOKAI) No. 2006-227632, for example), or a developer removal-type protective film that is removed during development in the step (3) (see WO2005-069076 and WO2006-035790, for example) may be used as the protective film. It is preferable to use the developer removal-type protective film from the viewpoint of throughput.

In the step (1), a photoresist film is formed by applying a resin composition solution obtained by dissolving the resin composition according to one embodiment of the invention in a solvent to a substrate (e.g., silicon wafer or a wafer coated with silicon dioxide) by an appropriate application method (e.g., rotational coating, cast coating, or roll coating). Specifically, the resin composition solution is applied to the substrate so that the resulting resist film has a given thickness, and pre-baked (PB) to volatilize the solvent from the film to obtain a resist film.

The thickness of the resist film is not particularly limited, but is preferably 0.1 to 5 µm, and more preferably 0.1 to 2 µm.

The PB temperature is determined depending on the composition of the radiation-sensitive resin composition, but is preferably 30 to 200°C, and more preferably 50 to 150°C.

When forming a photoresist pattern using the radiation-sensitive resin composition according to one embodiment of the invention, an organic or inorganic antireflective film may be formed on the substrate in order to bring out the potential of the radiation-sensitive resin composition to a maximum extent (see Japanese Examined Patent Publication (KOKOKU) No. 6-12452, for example). A protective film may be formed on the photoresist film to prevent an adverse effect of basic impurities and the like contained in the environmental atmosphere (see Japanese Patent Application Publication (KOKAI) No. 5-188598, for example). The above immersion liquid protective film may also be formed on the photoresist film. These methods may be used in combination.

In the step (2), the photoresist film formed by the step (1) is exposed by applying radiation to the photoresist film (optionally via an immersion medium such as water). In this case, radiation is applied via a mask having a given pattern.

Radiation used for exposure is appropriately selected from visible rays, ultraviolet rays, deep ultraviolet rays, X-rays, charged particle rays, and the like depending on the type of acid generator. It is preferable to use deep ultraviolet rays such as ArF excimer laser light (wavelength: 193 nm) or KrF excimer laser light (wavelength: 248 nm). It is particularly preferable to use ArF excimer laser light.

The exposure conditions (e.g., dose) are appropriately determined depending on the composition of the radiation-sensitive resin composition, the type of additive, and the like. It is preferable to perform post-exposure bake (PEB) after exposure. PEB ensures smooth dissociation of the acid-dissociable group in the polymer component. The PEB temperature is determined depending on the composition of the radiation-sensitive resin composition, but is preferably 30 to 200°C, and more preferably 50 to 170°C.

In the step (3), the exposed photoresist film is developed using a developer to form a given photoresist pattern. After development, the photoresist film (pattern) is normally washed with water, and dried.

An alkaline aqueous solution prepared by dissolving at least one alkaline compound (e.g., sodium hydroxide, potassium hydroxide, sodium carbonate, sodium silicate, sodium metasilicate, aqueous ammonia, ethylamine, n-propylamine, diethylamine, di-n-propylamine, triethylamine, methyldiethylamine, ethyldimethylamine, triethanolamine, tetramethylammonium hydroxide, pyrrole, piperidine, choline, 1,8-diazabicyclo-[5.4.0]-7-undecene, or 1,5-diazabicyclo-[4.3.0]-5-nonene) in water is preferably used as the developer. The concentration of the alkaline aqueous solution is normally 10 mass% or less. If the concentration of the alkaline aqueous solution exceeds 10 mass%, the unexposed area may be dissolved in the developer.

The developer may be a mixture prepared by adding an organic solvent to the above alkaline aqueous solution. Examples of the organic solvent include ketones such as acetone, methyl ethyl ketone, methyl i-butyl ketone, cyclopentanone, cyclohexanone, 3-methylcyclopentanone, and 2,6-dimethylcyclohexanone; alcohols such as methanol, ethanol, n-propyl alcohol, i-propyl alcohol, n-butyl alcohol, t-butyl alcohol, cyclopentanol, cyclohexanol, 1,4-hexanediol, and 1,4-hexanedimethylol; ethers such as tetrahydrofuran and dioxane; esters such as ethyl acetate, n-butyl acetate, and i-amyl acetate; aromatic hydrocarbons such as toluene and xylene; phenol, acetonylacetone, dimethylformamide; and the like. These organic solvents may be used either individually or in combination.

The organic solvent is preferably used in an amount of 100 parts by volume or less based on 100 parts by volume of the alkaline aqueous solution. If the amount of the organic solvent exceeds 100 parts by volume, the exposed area may remain undeveloped due to a decrease in developability. An appropriate amount of surfactant or the like may be added to the developer.

### EXAMPLES

The invention is further described below by way of examples. Note that the invention is not limited to the following examples. In the examples and comparative examples, the unit "parts" refers to "parts by mass", and the unit "%" refers to "mass%", unless otherwise indicated. The property value measuring methods and the property evaluation methods employed in the examples and comparative examples are given below.

### [Mw, Mn, and Mw/Mn]

The Mw and the Mn of each polymer were measured by gel permeation chromatography (GPC) using GPC columns (manufactured by Tosoh Corp., G2000HXL×2, G3000HXL×1, G4000HXL×1) (standard: monodisperse polystyrene, flow rate: 1.0 ml/min, eluant: tetrahydrofuran, column temperature: 40°C). The dispersity (Mw/Mn) was calculated from the Mw and Mn measurement results.

### [¹³C-NMR analysis]

Each polymer was subjected to ¹³C-NMR analysis using a nuclear magnetic resonance spectrometer ("JNM-ECX400" manufactured by JEOL Ltd.).

### [Residual rate of low-molecular-weight components]

The residual rate of low-molecular-weight components was measured by high-performance liquid chromatography (HPLC) using "Intersil ODS-25 µm column" (manufactured by GL Sciences Inc., 4.6 mm (diameter) × 250 mm) at a flow rate of 1.0 ml/min using an acrylonitrile/0.1% phosphoric acid aqueous solution as an eluant. Note that the low-molecular-weight components are components containing a monomer as the component and having a molecular weight of less than 1000 (i.e. a molecular weight equal to or less than that of a trimer).

### (Synthesis of polymer (A))

In each synthesis example, polymers (A-1) to (A-31) were synthesized using the following monomers (M-1) to (M-17). The monomers (M-12) to (M-15) correspond to the repeating unit (a-1), the monomers (M-1) and (M-8) correspond to the repeating unit (a-2), the monomers (M-2), (M-3), and (M-11) correspond to the repeating unit (a-3a), the monomers (M-7) and (M-10) correspond to the repeating unit (a-3b), and the monomers (M-5), (M-16), and (M-17) correspond to a repeating unit that includes one or more polar groups.

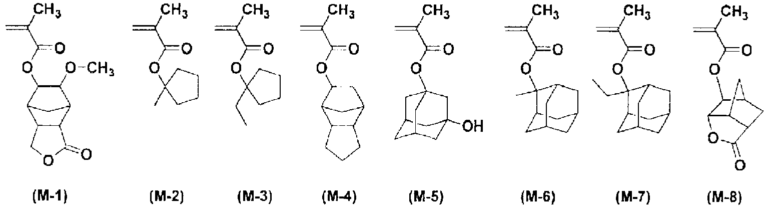

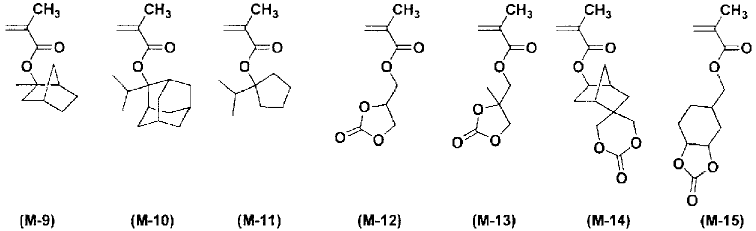

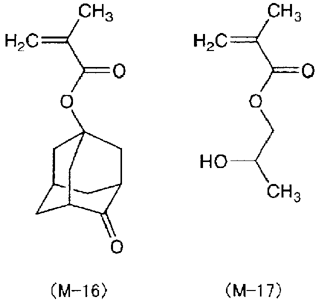

### (Synthesis Example 1: Polymer (A-1))

A monomer solution was prepared by dissolving 26.50 g (50 mol%) of the monomer (M-6), 8.42 g (20 mol%) of the monomer (M-12), and 15.08 g (30 mol%) of the monomer (M-8) in 100 g of 2-butanone, and adding 1.91 g (5 mol%) of dimethyl 2,2'-azobis(2-methylpropionate) (initiator) to the solution.

A 500 ml three-necked flask equipped with a thermometer and a dropping funnel was charged with 50 g of 2-butanone, and purged with nitrogen for 30 minutes. The inside of the flask was then heated to 80°C with stirring using a magnetic stirrer. The monomer solution was added dropwise to the flask using the dropping funnel over three hours. The monomers were polymerized for six hours from the start of the addition of the monomer solution. After completion of polymerization, the polymer solution was cooled with water to 30°C or less. The polymer solution was then added to 1000 g of methanol, and a white powder precipitated was collected by filtration. The white powder thus collected was washed twice with 200 g of methanol in a slurry state. The white powder was then collected by filtration, and dried at 50°C for 17 hours to obtain a white powdery copolymer (37 g, yield: 74%). This copolymer is referred to as "polymer (A-1)".

The copolymer had an Mw of 7321 and an Mw/Mn ratio of 1.70. The ratio of repeating units derived from the monomers (M-6), (M-12), and (M-8) determined by ¹³C-NMR analysis was 45.2:19.5:35.3 (mol%). The residual rate of low-molecular-weight components in the copolymer was 0.05 mass%. The measurement results are shown in Table 2.

**TABLE 1**

| Polymer A | Monomer (mass%) | | | | | | | | | | | | | | |
|---|---|---|---|---|---|---|---|---|---|---|---|---|---|---|---|
| | M-1 | M-2 | M-3 | M-4 | M-5 | M-6 | M-7 | M-8 | M-9 | M-10 | M-11 | M-12 | M-13 | M-14 | M-15 |
| A-1 | - | - | - | - | - | 50.0 | - | 30.0 | - | - | - | 20.0 | - | - | - |
| A-2 | - | - | - | - | - | - | 50.0 | 30.0 | - | - | - | 20.0 | - | - | - |
| A-3 | - | - | - | - | - | - | - | 30.0 | 50.0 | - | - | 20.0 | - | - | - |
| A-4 | - | - | - | - | - | 50.0 | - | - | - | - | - | 50.0 | - | - | - |
| A-5 | - | - | - | - | - | - | 50.0 | - | - | - | - | 50.0 | - | - | - |
| A-6 | - | - | - | - | - | - | - | - | 50.0 | - | - | 50.0 | - | - | - |
| A-7 | - | - | 15.0 | - | - | 35.0 | - | 30.0 | - | - | - | 20.0 | - | - | - |
| A-8 | - | - | 25.0 | - | - | 25.0 | - | 30.0 | - | - | - | - | 20.0 | - | - |
| A-9 | - | - | 35.0 | - | - | 15.0 | - | 30.0 | - | - | - | - | - | 20.0 | - |
| A-10 | - | 35.0 | - | - | - | - | 15.0 | 30.0 | - | - | - | 20.0 | - | - | - |
| A-11 | - | 30.0 | - | - | - | - | 10.0 | 50.0 | - | - | - | - | - | - | 10.0 |
| A-12 | - | 40.0 | - | - | 10.0 | - | 40.0 | - | - | - | - | - | 10.0 | - | - |
| A-13 | - | - | 30.0 | 10.0 | - | - | - | 40.0 | - | - | - | - | - | 20.0 | - |
| A-14 | - | - | - | - | - | - | - | - | - | 35.0 | 15.0 | 50.0 | - | - | - |

**TABLE 2**

| Polymer A | Ratio of monomers in polymer (mol%) | | | | | | | | | | | | | | | Mw | Mw/Mn | Yield (%) |
|---|---|---|---|---|---|---|---|---|---|---|---|---|---|---|---|---|---|---|
| | M-1 | M-2 | M-3 | M-4 | M-5 | M-6 | M-7 | M-8 | M-9 | M-10 | M-11 | M-12 | M-13 | M-14 | M-15 | | | |
| A-1 | - | - | - | - | - | 45.2 | - | 35.3 | - | - | - | 19.5 | - | - | - | 7321 | 1.70 | 74 |
| A-2 | - | - | - | - | - | - | 44.1 | 36.3 | - | - | - | 19.6 | - | - | - | 6894 | 1.67 | 66 |
| A-3 | - | - | - | - | - | - | - | 36.1 | 44.6 | - | - | 19.3 | - | - | - | 7149 | 1.67 | 77 |
| A-4 | - | - | - | - | - | 52.0 | - | - | - | - | - | 48.0 | - | - | - | 7219 | 1.68 | 71 |
| A-5 | - | - | - | - | - | - | 39.4 | - | - | - | - | 60.6 | - | - | - | 6874 | 1.64 | 76 |
| A-6 | - | - | - | - | - | - | - | - | 51.4 | - | - | 48.6 | - | - | - | 7178 | 1.67 | 78 |
| A-7 | - | - | 12.9 | - | - | 28 | - | 35.4 | - | - | - | 23.7 | - | - | - | 6812 | 1.70 | 77 |
| A-8 | - | - | 27.8 | - | - | 21.7 | - | 31.8 | - | - | - | - | 18.7 | - | - | 6113 | 1.68 | 79 |
| A-9 | - | - | 39.8 | - | - | 14.7 | - | 25.1 | - | - | - | - | - | 20.4 | - | 7482 | 1.71 | 77 |
| A-10 | - | 39.3 | - | - | - | - | 14.3 | 24.9 | - | - | - | 21.5 | - | - | - | 5817 | 1.68 | 80 |
| A-11 | - | 30.7 | - | - | - | - | 8.2 | 51.5 | - | - | - | - | - | - | 9.6 | 6284 | 1.69 | 64 |
| A-12 | - | 42.7 | - | - | 9.9 | - | 36.2 | - | - | - | - | - | 11.2 | - | - | 5223 | 1.69 | 73 |
| A-13 | - | - | 29.0 | 9.2 | - | - | - | 42.1 | - | - | - | - | - | 19.7 | - | 7106 | 1.75 | 79 |
| A-14 | - | - | - | - | - | - | - | - | - | 33.1 | 12.5 | 54.4 | - | - | - | 7413 | 1.72 | 64 |

### (Synthesis Examples 2 to 31: Polymers (A-2) to (A-31))

Polymers (A-2) to (A-31) were synthesized in the same manner as in Synthesis Example 1, except for using a composition shown in Table 1, 3, or 5.

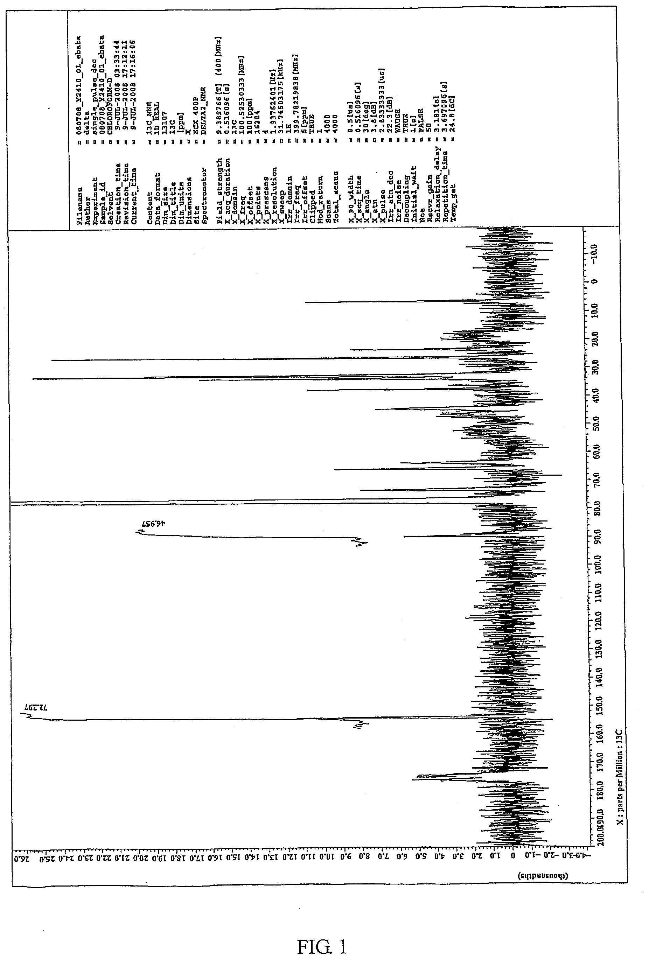

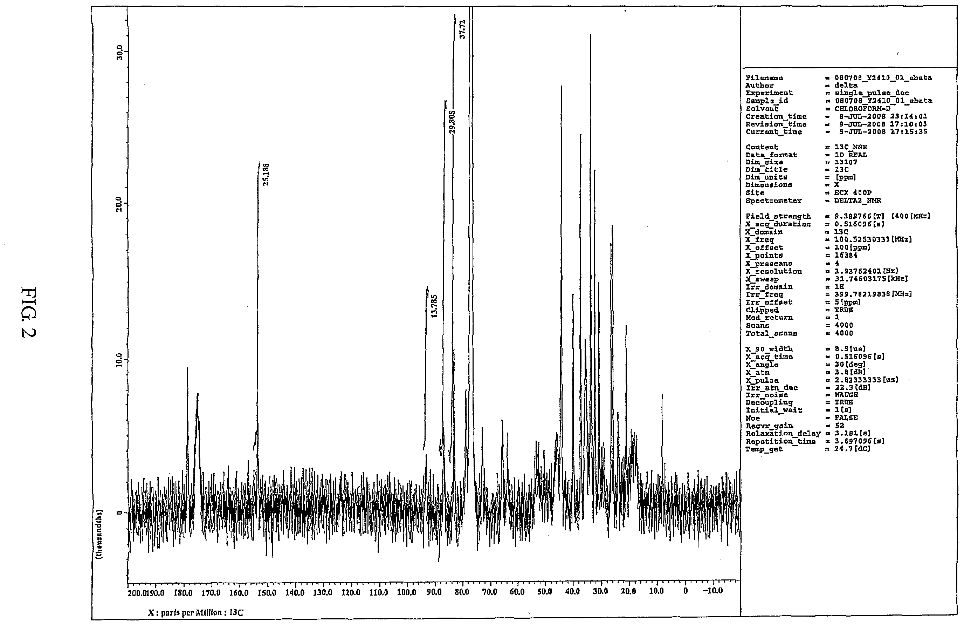

The ratio (mol%) of repeating units determined by ¹³C-NMR analysis, the yield (%), the Mw, and the dispersity(Mw/Mn) of the polymers (A-2) to (A-31) are shown in Tables 2, 4, and 6. FIGS. 1 and 2 show the ¹³C-NMR charts of the polymers (A-5) and (A-7).

**TABLE 3**

| Polymer A | Monomer (mass%) | | | | | | | | | | | | | | |
|---|---|---|---|---|---|---|---|---|---|---|---|---|---|---|---|
| | M-1 | M-2 | M-3 | M-4 | M-5 | M-6 | M-7 | M-8 | M-9 | M-10 | M-11 | M-12 | M-13 | M-14 | M-15 |
| A-15 | - | - | - | - | - | 50.0 | - | 50.0 | - | - | - | - | - | - | - |
| A-16 | - | - | - | - | - | - | 50.0 | 50.0 | - | - | - | - | - | - | - |
| A-17 | - | - | - | - | - | - | - | 50.0 | 50.0 | - | - | - | - | - | - |
| A-18 | - | - | 15.0 | - | - | 35.0 | - | 50.0 | - | - | - | - | - | - | - |
| A-19 | - | - | 25.0 | - | - | 25.0 | - | 50.0 | - | - | - | - | - | - | - |
| A-20 | - | - | 35.0 | - | - | 15.0 | - | 50.0 | - | - | - | - | - | - | - |
| A-21 | - | 35.0 | - | - | - | - | 15.0 | 50.0 | - | - | - | - | - | - | - |
| A-22 | - | 30.0 | - | - | - | - | 10.0 | 60.0 | - | - | - | - | - | - | - |
| A-23 | 60.0 | - | - | - | 10.0 | - | 40.0 | - | - | - | - | - | - | - | - |
| A-24 | - | - | 30.0 | 10.0 | - | - | - | 60.0 | - | - | - | - | - | - | - |
| A-25 | - | - | - | - | - | - | - | 50.0 | - | 35.0 | 15.0 | - | - | - | - |

**TABLE 4**

| Polymer A | Ratio of monomers in polymer (mol%) | | | | | | | | | | | | | | | Mw | Mw/Mn | Yield (%) |
|---|---|---|---|---|---|---|---|---|---|---|---|---|---|---|---|---|---|---|
| | M-1 | M-2 | M-3 | M-4 | M-5 | M-6 | M-7 | M-8 | M-9 | M-10 | M-11 | M-12 | M-13 | M-14 | M-15 | | | |
| A-15 | - | - | - | - | - | 43.4 | - | 56.6 | - | - | - | - | - | - | - | 5261 | 1.71 | 85 |
| A-16 | - | - | - | - | - | - | 43.3 | 56.7 | - | - | - | - | - | - | - | 4664 | 1.63 | 66 |
| A-17 | - | - | - | - | - | - | - | 43.7 | 56.3 | - | - | - | - | - | - | 5427 | 1.73 | 73 |
| A-18 | - | - | 14.5 | - | - | 36.7 | - | 48.8 | - | - | - | - | - | - | - | 6708 | 1.72 | 78 |
| A-19 | - | - | 25.4 | - | - | 19.6 | - | 54.9 | - | - | - | - | - | - | - | 6000 | 1.70 | 79 |
| A-20 | - | - | 33.6 | - | - | 13.2 | - | 53.2 | - | - | - | - | - | - | - | 7452 | 1.72 | 80 |
| A-21 | - | 34.3 | - | - | - | - | 15.5 | 50.2 | - | - | - | - | - | - | - | 5768 | 1.70 | 68 |
| A-22 | - | 28.3 | - | - | - | - | 7.6 | 64.1 | - | - | - | - | - | - | - | 6210 | 1.71 | 67 |
| A-23 | 61.0 | - | - | - | 9.6 | - | 39.4 | - | - | - | - | - | - | - | - | 5103 | 1.69 | 71 |
| A-24 | - | - | 29.1 | 9.1 | - | - | - | 61.8 | - | - | - | - | - | - | - | 7105 | 1.75 | 70 |
| A-25 | - | - | - | - | - | - | - | 55.1 | - | 33.0 | 11.9 | - | - | - | - | 7632 | 1.74 | 81 |

**TABLE 5**

| Polymer A | Monomer (mass%) | | | | | | | | | | | | | | | | |
|---|---|---|---|---|---|---|---|---|---|---|---|---|---|---|---|---|---|
| | M-1 | M-2 | M-3 | M-4 | M-5 | M-6 | M-7 | M-8 | M-9 | M-10 | M-11 | M-12 | M-13 | M-14 | M-15 | M-16 | M-17 |
| A-26 | - | - | - | 10 | - | 50 | - | - | - | - | - | 40 | - | - | - | - | - |
| A-27 | - | 50 | - | 10 | - | - | - | - | - | - | - | 40 | - | - | - | - | - |
| A-28 | - | - | - | - | 10 | 50 | - | - | - | - | - | 40 | - | - | - | - | - |
| A-29 | - | 50 | - | - | 1 10 | - | - | - | - | - | - | 40 | - | - | - | - | - |
| A-30 | - | - | - | - | - | 50 | - | - | - | - | - | 40 | - | - | - | 10 | - |
| A-31 | - | - | - | - | - | 50 | - | - | - | - | - | 40 | - | - | - | - | 10 |

**TABLE 6**

| Polymer A | Ratio of monomers in polymer (mol%) | | | | | | | | | | | | | | | | | Mw | Mw/Mn | Yield (%) |
|---|---|---|---|---|---|---|---|---|---|---|---|---|---|---|---|---|---|---|---|---|
| | M-1 | M-2 | M-3 | M-4 | M-5 | M-6 | M-7 | M-8 | M-9 | M-10 | M-11 | M-12 | M-13 | M-14 | M-15 | M-16 | M-17 | | | |
| A-26 | - | - | - | 9.5 | - | 50.2 | - | - | - | - | - | 40.3 | - | - | - | - | - | 6520 | 1.61 | 78 |
| A-27 | - | 48.7 | - | 9.7 | - | - | - | - | - | - | - | 41.6 | - | - | - | - | - | 8690 | 1.77 | 75 |
| A-28 | - | - | - | - | 9.7 | 50.6 | - | - | - | - | - | 39.7 | - | - | - | - | - | 7221 | 1.70 | 76 |
| A-29 | - | 48.9 | - | - | 9.9 | - | - | - | - | - | - | 41.2 | - | - | - | - | - | 8830 | 1.83 | 73 |
| A-30 | - | - | - | - | - | 49.7 | - | - | - | - | - | 40.5 | - | - | - | 9.8 | - | 7010 | 1.71 | 75 |
| A-31 | - | - | - | - | - | 50.1 | - | - | - | - | - | 41.0 | - | - | - | - | 8.9 | 7100 | 1.70 | 68 |

### (Synthesis of acid diffusion controller (C))

Compounds used as acid diffusion controllers (C-9) to (C-11) were synthesized. These compounds correspond to the photodegradable base (C-2).

### (Synthesis Example 32: Photodegradable base (C-9))

20 g of an ion-exchange resin ("QAE Sephadex A-25" manufactured by GE Healthcare Biosciences) was swollen overnight in ultrapure water, and then introduced into a column tube. A solution prepared by dissolving 28 g of a sodium salt shown by the following formula (X-1) in methanol was introduced into the column tube charged with the ion-exchange resin so that the sulfonamide anion was supported on the ion-exchange resin. After backflushing with a sufficient amount of methanol, a solution prepared by dissolving 5.2 g of triphenylsulfonium chloride in methanol was introduced into the column tube to effect an anion exchange reaction. After evaporating the solvent from the resulting solution using an evaporator, the residue was dried at room temperature overnight to obtain a photodegradable base (C-9) shown by the following formula (C-9) (yield: 8.0 g).

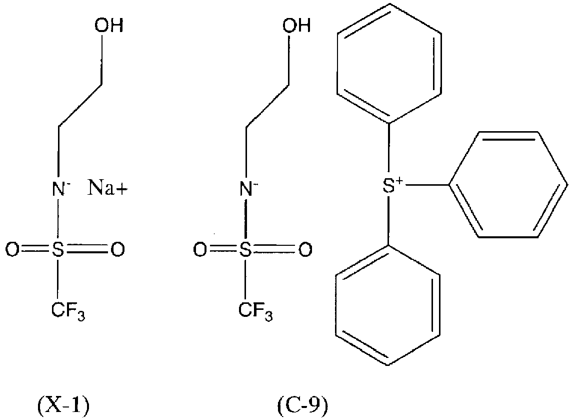

### (Synthesis Example 33: Photodegradable base (C-10))

A photodegradable base (C-10) shown by the following formula (C-10) was obtained in the same manner as in Synthesis Example 32, except for introducing a solution prepared by dissolving 5.6 g of diphenyliodonium chloride in methanol into the column tube to effect an anion exchange reaction (yield: 8.2 g).

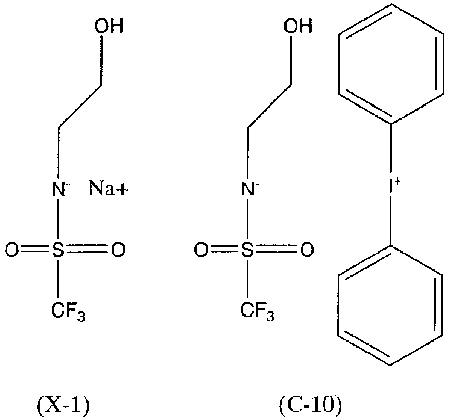

### (Synthesis Example 34: Photodegradable base (C-11))

20 g of the above ion-exchange resin was swollen overnight in ultrapure water, and then introduced into a column tube. A sodium salt shown by the following formula (X-2) was prepared in advance by deprotonating an (X-2) derivative (manufactured by Central Glass Co., Ltd.) with a metal base (sodium hydrogen carbonate). A solution prepared by dissolving 28 g of the sodium salt in methanol was introduced into the column tube so that the sulfonamide anion was supported on the ion-exchange resin. After backflushing with a sufficient amount of methanol, a solution prepared by dissolving 5.2 g of triphenylsulfonium chloride in methanol was introduced into the column tube to effect an anion exchange reaction. After evaporating the solvent from the resulting solution using an evaporator, the residue was dried at room temperature overnight to obtain a photodegradable base (C-11) shown by the following formula (C-11) (yield: 8.1 g).

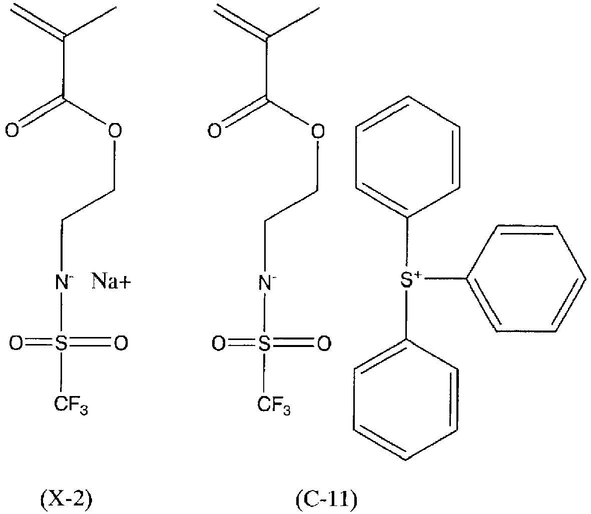

### (Production of radiation-sensitive resin composition)

Tables 7 and 8 show the composition of the radiation-sensitive resin compositions prepared in the examples and comparative examples. The components (acid generator (B), acid diffusion controller (C), and solvent (D)) of the radiation-sensitive composition other than the polymers (A-1) to (A-31) and the acid diffusion controllers (C-9) to (C-11) synthesized in the synthesis examples are given below.

### <Acid generator (B)>

(B-1): 4-cyclohexylphenyldiphenylsulfonium nonafluoro-n-butanesulfonate
(B-2): triphenylsulfonium-nonafluoro-n-butanesulfonate
(B-3): 1-(4-n-butoxynaphthalen-1-yl)tetrahydrothiophenium nonafluoro-n-butanesulfonate
(B-4): 1-(4-n-butoxynaphthalen-1-yl)tetrahydrothiophenium 2-(bicyclo[2.2.1]heptan-2-yl)-1,1,2,2-tetrafluoroethanesulfonate
(B-5): triphenylsulfonium 2-(bicyclo[2.2.1]hept-2-yl)-1,1,2,2-tetrafluoroethanesulfonate
(B-6): triphenylsulfonium 2-(bicyclo[2.2.1]hept-2-yl)-1,1-difluoroethanesulfonate

### <Acid diffusion controller (C)>

(C-1): N-t-butoxycarbonyl-4-hydroxypiperidine
(C-2): (R)-(+)-(t-butoxycarbonyl)-2-piperidinemethanol
(C-3): N-t-butoxycarbonylpyrrolidine
(C-4): N-t-butoxycarbonyl-2-phenylbenzimidazole
(C-5): tri-n-octylamine
(C-6): phenyldiethanolamine
(C-7): triphenylsulfonium salicylate
(C-8): triphenylsulfonium camphorsulfonate

### Solvent (D)

(D-1): propylene glycol monomethyl ether acetate
(D-2): cyclohexanone
(D-3): γ-butyrolactone

**TABLE 7**

| | | Resin (parts) | Acid generator (parts) | Acid diffusion controller (parts) | Solvent (parts) |
|---|---|---|---|---|---|
| | 1 | A-1 (100) | B-2 (8.4) | C-2 (0.9) | D-1 (1500), D-2 (650), D-3 (40) |
| | 2 | A-2 (100) | B-6 (7.5) | C-1 (0.7) | D-1 (1500), D-2 (650), D-3 (40) |
| | 3 | A-3 (100) | B-2 (8.4) | C-3 (0.5), C-6 (0.4) | D-1 (1500), D-2 (650), D-3 (40) |
| | 4* | A-4 (100) | B-2 (8.4) | C-4 (1.5) | D-1 (1500), D-2 (650), D-3 (40) |
| | 5* | A-5 (100) | B-6 (7.5) | C-1 (0.7) | D-1 (1500), D-2 (650), D-3 (40) |
| | 6* | A-6 (100) | B-2 (8.4) | C-3 (0.8) | D-1 (1500), D-2 (650), D-3 (40) |
| | 7 | A-7 (100) | B-6 (7.5) | C-1 (0.7) | D-1 (1500), D-2 (650), D-3 (40) |
| | 8 | A-8 (100) | B-1 (8.5), B-3 (2.0) | C-2 (1.2) | D-1 (1500), D-2 (650), D-3 (40) |
| | 9 | A-9 (100) | B-4 (4.0), B-5 (6.0) | C-3 (1.1) | D-1 (1500), D-2 (650), D-3 (40) |
| Example | 10 | A-10 (100) | B-6 (7.5) | C-1 (0.7) | D-1 (1500), D-2 (650), D-3 (40) |
| | 11 | A-11 (100) | B-1 (9.6) | C-3 (0.9) | D-1 (1500), D-2 (650), D-3 (40) |
| | 12* | A-12 (100) | B-2 (8.4) | C-2 (0.9) | D-1 (1500), D-2 (650), D-3 (40) |
| | 13 | A-13 (100) | B-1 (9.6) | C-4 (1.5) | D-1 (1500), D-2 (650), D-3 (40) |
| | 14* | A-14 (100) | B-2 (8.4) | C-4 (1.5) | D-1 (1500), D-2 (650), D-3 (40) |
| | 15 | A-1 (100) | B-2 (8.4) | C-7 (4.5) | D-1 (1500), D-2 (650), D-3 (40) |
| | 16 | A-1 (100) | B-2 (8.4) | C-8 (4.5) | D-1 (1500), D-2 (650), D-3 (40) |
| | 17 | A-1 (100) | B-2 (8.4) | C-9 (4.5) | D-1 (1500), D-2 (650), D-3 (40) |
| | 18 | A-1 (100) | B-2 (8.4) | C-10 (4.5) | D-1 (1500), D-2 (650), D-3 (40) |
| | 19 | A-1 (100) | B-2 (8.4) | C-11 (4.5) | D-1 (1500), D-2 (650), D-3 (40) |
| Comparative Example | 1 | A-15 (100) | B-2 (8.4) | C-5 (1.8) | D-1 (1500), D-2 (650), D-3 (40) |
| | 2 | A-16 (100) | B-6 (7.5) | C-5 (1.2) | D-1 (1500), D-2 (650), D-3 (40) |
| | 3 | A-17 (100) | B-2 (8.4) | C-6 (0.9) | D-1 (1500), D-2 (650), D-3 (40) |
| | 4 | A-18 (100) | B-6 (7.5) | C-5 (1.2) | D-1 (1500), D-2 (650), D-3 (40) |
| | 5 | A-19 (100) | B-1 (8.5), B-3 (2.0) | C-6 (1.0) | D-1 (1500), D-2 (650), D-3 (40) |
| | 6 | A-20 (100) | B-4 (4.0), B-5 (6.0) | C-5 (2.2) | D-1 (1500), D-2 (650), D-3 (40) |
| | 7 | A-21 (100) | B-6 (7.5) | C-5 (1.2) | D-1 (1500), D-2 (650), D-3 (40) |
| | 8 | A-22 (100) | B-1 (9.6) | C-6 (0.9) | D-1 (1500), D-2 (650), D-3 (40) |
| | 9 | A-23 (100) | B-2 (8.4) | C-6 (0.9) | D-1 (1500), D-2 (650), D-3 (40) |
| | 10 | A-24 (100) | B-1 (9.6) | C-5 (1.8) | D-1 (1500), D-2 (650), D-3 (40) |
| | 11 | A-25 (100) | B-2 (8.4) | C-5 (1.5) | D-1 (1500), D-2 (650), D-3 (40) |

| | | | | | |
|---|---|---|---|---|---|
| * Reference Example | | | | | |

**TABLE 8**

| | | Resin (parts) | Acid generator (parts) | Acid diffusion controller (parts) | Solvent (parts) |
|---|---|---|---|---|---|
| Example | 20* | A-26 (100) | B-6 (7.5) | C-1 (0.9) | D-1 (1500), D-2 (650), D-3 (30) |
| | 21* | A-27 (100) | B-6 (7.5) | C-1 (0.9) | D-1 (1500), D-2 (650), D-3 (30) |
| | 22* | A-28 (100) | B-6 (7.5) | C-1 (0.9) | D-1 (1500), D-2 (650), D-3 (30) |
| | 23* | A-29 (100) | B-6 (7.5) | C-1 (0.9) | D-1 (1500), D-2 (650), D-3 (30) |
| | 24* | A-30 (100) | B-6 (7.5) | C-1 (0.9) | D-1 (1500), D-2 (650), D-3 (30) |
| | 25* | A-31 (100) | B-6 (7.5) | C-1 (0.9) | D-1 (1500), D-2 (650), D-3 (30) |

| | | | | | |
|---|---|---|---|---|---|
| * Reference Example | | | | | |

### (Example 1)

100 parts by mass of the polymer (A-1) obtained in Synthesis Example 1, 8.4 parts by mass of triphenylsulfonium nonafluoro-n-butanesulfonate (B-2) (acid generator (B)), and 0.9 parts by mass of (R)-(+)-(t-butoxycarbonyl)-2-piperidinemethanol (C-2) (acid diffusion controller (C)) were mixed. 1500 parts by mass of propylene glycol monomethyl ether acetate (D-1), 650 parts by mass of cyclohexanone (D-2), and 40 parts by mass of γ-butyrolactone (D-3) (solvent (D)) were added to the mixture to obtain a mixed solution. The resulting mixed solution was filtered through a filter having a pore size of 0.20 µm to obtain a radiation-sensitive resin composition. Table 3 shows the composition of the radiation-sensitive resin composition.

### (Examples 2, 3, 7 to 11, 13, and 15 to 19, Reference Examples 4 to 6, 12, 14 and 20 to 25 and Comparative Examples 1 to 11)

Radiation-sensitive resin compositions (Examples 2, 3, 7 to 11, 13, and 15 to 19, Reference Examples 4 to 6, 12, 14 and 20 to 25 and Comparative Examples 1 to 11) were obtained in the same manner as in Example 1, except for changing the components as shown in Tables 7 and 8.

### [Evaluation methods]

The sensitivity, the dense line depth of focus, the isolated space depth of focus, the LWR, the MEEF, the minimum CD (critical dimension), the exposure latitude, the cross-sectional pattern shape, and the number of development defects of the radiation-sensitive resin compositions obtained in Examples 1 to 3, 7 to 11, 13, and 15 to 19, Reference Examples 4 to 6, 12, 14 and 20 to 25 and Comparative Examples 1 to 11 were evaluated using an ArF excimer laser as a light source. The evaluation results are shown in Tables 9 and 10.

### (1) Sensitivity (mJ/cm²)

An underlayer antireflective film having a thickness of 77 nm was formed on the surface of an 8-inch wafer (substrate) using a material "ARC29A" (manufactured by Nissan Chemical Industries, Ltd.). The radiation-sensitive resin composition of each example and comparative example was spin-coated onto the surface of the substrate, and soft-baked (SB) for 90 seconds on a hot plate at a temperature shown in Table 4 to form a resist film having a thickness of 120 nm.

The resist film was exposed via a mask pattern using a full-field projection aligner ("S306C" manufactured by Nikon Corp., NA: 0.78). After performing PEB for 90 seconds at a temperature shown in Table 4, the resist film was developed at 25°C for 60 seconds using a 2.38 mass% tetramethylammonium hydroxide aqueous solution (hereinafter referred to as "TMAH aqueous solution"), washed with water, and dried to form a positive-tone resist pattern.

An optimum dose (mJ/cm²) at which a 1:1 line-and-space (1L/1S) pattern having a line width of 90 nm was formed using a 1:1 line-and-space mask having a line width of 90 nm was taken as the sensitivity. The measurement was carried out using a scanning electron microscope ("S-9220" manufactured by Hitachi High-Technologies Corporation).

### (2) Dense line depth of focus (µm)

A focus amplitude when pattern size resolved at the optimum dose using a 90 nm 1L/1S mask pattern were within ±10% of the design size of the mask was taken as the dense line depth of focus. A case where the dense line depth of focus was 0.40 µm or more was evaluated as "Good", and a case where the dense line depth of focus was less than 0.40 µm was evaluated as "Bad". The pattern size was measured using the above scanning electron microscope.

### (3) Isolated space depth of focus (µm)

A focus amplitude when 90 nmS/1150 nmP pattern size resolved at the optimum dose using a 115 nmS/1150 nmP mask pattern were within the range of 81 to 99 nmS/1150 nmP was taken as the isolated space depth of focus (µm). A case where the isolated space depth of focus was 0.20 µm or more was evaluated as "Good", and a case where the isolated space depth of focus was less than 0.20 µm was evaluated as "Bad". The pattern size was measured using the above scanning electron microscope.

### (4) LWR (nm)

A 90 nm 1L/1S pattern resolved at the optimum dose was observed from above using the scanning electron microscope. The line width was measured at an arbitrary ten points, and a variation (3σ) in measured values was taken as the LWR. A case where the LWR was 8.0 nm or less was evaluated as "Good", and a case where the LWR was more than 8.0 nm was evaluated as "Bad".

### (5) MEEF

The size of a pattern resolved at the optimum dose using each mask (85.0 nmL/180 nmP, 87.5 nmL/180 nmP, 90.0 nmL/180 nmP, 92.5 nmL/180 nmP, or 95.0 nmL/180 nmP) were measured using the above scanning electron microscope. The mask size (horizontal axis) and the line width (vertical axis) were plotted on a graph, and the slope of the graph was determined by a least-square method. The slope thus determined was taken as the MEEF. A case where the MEEF was 4.0 or more was evaluated as "Good", and a case where the MEEF was less than 4.0 was evaluated as "Bad".

### (6) Minimum CD (nm)

When the 90 nm line-and-space pattern (see sensitivity evaluation) is resolved at a dose higher than the optimum dose, the resulting pattern has a small line width, and the resist pattern collapses. A line width at the maximum dose at which the resist pattern does not collapse was defined as the minimum CD (nm). The minimum CD was used as an index of the pattern collapse resistance. A case where the minimum CD was 40.0 nm or less was evaluated as "Good", and a case where the minimum CD was more than 40.0 nm was evaluated as "Bad". The minimum CD was measured using the above scanning electron microscope.

### (7) Number of development defects (per wafer)

The number of development defects was evaluated by the following method using a defect inspection system ("KLA2351" manufactured by KLA-Tencor Corporation). A defect inspection wafer was prepared as follows. Specifically, an underlayer antireflective film-forming material ("ARC25" manufactured by Brewer Science, Inc.) was applied to a wafer to a thickness of 820 angstroms to obtain a wafer substrate. In only Examples 22 to 25, the underlayer antireflective film-forming material was applied to a wafer to a thickness of 770 angstroms to obtain a wafer substrate. The radiation-sensitive resin composition of each example and comparative example was applied to the substrate to a thickness of 0.30 µm, and soft-baked (SB) for 90 seconds at a temperature shown in Table 4. In only Examples 22 to 25, the radiation-sensitive resin composition was applied to the wafer substrate to a thickness of 0.12 µm.

The entire wafer was exposed (5×5 mm blank exposure) using a full-field exposure system ("S306C" manufactured by Nikon Corporation). After performing PEB at 130°C for 90 seconds, the composition was developed at 25°C for 30 seconds using a 2.38 wt% TMAH aqueous solution, washed with water, and dried to obtain a defect inspection wafer. The composition was applied, fired, and developed in-line using a coater/developer ("CLEANTRACK ACT8" manufactured by Tokyo Electron Ltd.).

The total number of development defects in the exposed area of the defect inspection wafer was measured using the above defect inspection system. Specifically, the total number of clustered/unclustered defects extracted from the difference due to pixel-unit superimposition with a reference image was detected by array-mode observation. The sensitivity of the defect inspection system was set so that defects having a size of 0.15 µm or more could be detected. A case where the number of development defects was 30 or less per wafer was evaluated as "Good", and a case where the number of development defects was more than 30 per wafer was evaluated as "Bad".

### (8) Exposure latitude (EL)

The ratio of the dose range in which the pattern size resolved via a 90 nm 1L/1S mask pattern were within ±10% of the design size of the mask to the optimum dose was taken as the exposure latitude. A case where the exposure latitude was 10% or more was evaluated as "Good", and a case where the exposure latitude was less than 10% was evaluated as "Bad". The pattern size was measured using the above scanning electron microscope.

### (9) Cross-sectional pattern shape

The cross-sectional shape of the 90 nm line-and-space pattern resolved at the above sensitivity was observed using a scanning electron microscope ("S-4200" manufactured by Hitachi High-Technologies Corporation) to measure the line width Lb in the intermediate area of the resist pattern and the line width La in the upper area of the resist pattern. A case where "0.9≤(La/Lb)≤1.1" was satisfied was evaluated as "Good", and a case where "0.9≤(La/Lb)≤1.1" was not satisfied was evaluated as "Bad".

**TABLE 9**

| | | SB (°C) | PEB (°C) | Sensitivity (mJ/cm²) | Dense line depth of focus (µm) | Isolated space depth of focus (µm) | LWR (nm) | MEEF | Minimum CD (nm) | Number of development defects (/wafer) |
|---|---|---|---|---|---|---|---|---|---|---|
| | 1 | 100 | 110 | 38 | 0.45 (Good) | 0.20 (Good) | 7.5 (Good) | 2.4 (Good) | 32.4 (Good) | 3 (Good) |
| | 2 | 100 | 85 | 39 | 0.45 (Good) | 0.20 (Good) | 6.9 (Good) | 2.8 (Good) | 31.7 (Good) | 4 (Good) |
| | 3 | 100 | 90 | 41 | 0.45 (Good) | 0.20 (Good) | 7.4 (Good) | 2.8 (Good) | 34.5 (Good) | 7 (Good) |
| | 4* | 110 | 110 | 36 | 0.45 (Good) | 0.20 (Good) | 7.8 (Good) | 3.7 (Good) | 38.7 (Good) | 11 (Good) |
| | 5* | 100 | 85 | 37 | 0.45 (Good) | 0.20 (Good) | 8.0 (Good) | 3.9 (Good) | 39.6 (Good) | 14 (Good) |
| | 6* | 100 | 90 | 40 | 0.45 (Good) | 0.20 (Good) | 7.9 (Good) | 3.9 (Good) | 39.8 (Good) | 18 (Good) |
| | 7 | 100 | 110 | 38 | 0.45 (Good) | 0.25 (Good) | 7.0 (Good) | 2.9 (Good) | 34.6 (Good) | 1 (Good) |
| | 8 | 120 | 110 | 35 | 0.45 (Good) | 0.25 (Good) | 6.9 (Good) | 3.5 (Good) | 36.4 (Good) | 5 (Good) |
| | 9 | 90 | 105 | 36 | 0.45 (Good) | 0.25 (Good) | 6.8 (Good) | 3.5 (Good) | 37.5 (Good) | 3 (Good) |
| Example | 10 | 100 | 100 | 42 | 0.45 (Good) | 0.25 (Good) | 6.3 (Good) | 3.4 (Good) | 38.3 (Good) | 21 (Good) |
| | 11 | 110 | 105 | 41 | 0.45 (Good) | 0.20 (Good) | 6.7 (Good) | 3.3 (Good) | 36.8 (Good) | 18 (Good) |
| | 12* | 100 | 90 | 33 | 0.45 (Good) | 0.20 (Good) | 7.2 (Good) | 3.3 (Good) | 34.2 (Good) | 9 (Good) |
| | 13 | 100 | 120 | 36 | 0.40 (Good) | 0.25 (Good) | 6.0 (Good) | 3.3 (Good) | 38.6 (Good) | 2 (Good) |
| | 14* | 100 | 85 | 36 | 0.40 (Good) | 0.25 (Good) | 7.8 (Good) | 3.7 (Good) | 36.1 (Good) | 23 (Good) |
| | 15 | 100 | 110 | 40 | 0.45 (Good) | 0.20 (Good) | 5.9 | 2.1 | 39.7 | 26 (Good) |
| | 16 | 100 | 110 | 36 | 0.45 (Good) | 0.20 (Good) | 6.0 | 2.3 | 39.4 | 27 (Good) |
| | 17 | 100 | 110 | 40 | 0.45 (Good) | 0.20 (Good) | 5.8 | 2.1 | 39.1 | 25 (Good) |
| | 18 | 100 | 110 | 48 | 0.45 (Good) | 0.20 (Good) | 5.9 | 2.1 | 39.7 | 26 (Good) |
| | 19 | 100 | 110 | 42 | 0.45 (Good) | 0.20 (Good) | 6.0 | 2.2 | 39.9 | 29 (Good) |
| Comparative Example | 1 | 100 | 110 | 39 | 0.40 (Good) | 0.10 (Bad) | 9.1 (Bad) | 4.2 (Bad) | 42.3 (Bad) | 24 (Good) |
| | 2 | 100 | 85 | 40 | 0.40 (Good) | 0.10 (Bad) | 8.2 (Bad) | 4.3 (Bad) | 41.2 (Bad) | 28 (Good) |
| | 3 | 100 | 90 | 42 | 0.40 (Good) | 0.10 (Bad) | 8.4 (Bad) | 4.4 (Bad) | 44.5 (Bad) | 34 (Bad) |
| | 4 | 110 | 110 | 40 | 0.45 (Good) | 0.10 (Bad) | 8.1 (Bad) | 4.3 (Bad) | 41.0 (Bad) | 42 (Bad) |
| | 5 | 120 | 110 | 35 | 0.45 (Good) | 0.10 (Bad) | 7.9 (Good) | 4.6 (Bad) | 48.5 (Bad) | 30 (Good) |
| | 6 | 90 | 105 | 37 | 0.45 (Good) | 0.15 (Bad) | 7.4 (Good) | 4.7 (Bad) | 51.4 (Bad) | 28 (Good) |
| | 7 | 100 | 100 | 44 | 0.45 (Good) | 0.15 (Bad) | 7.6 (Good) | 4.8 (Bad) | 56.7 (Bad) | 112 (Bad) |
| | 8 | 110 | 105 | 42 | 0.45 (Good) | 0.10 (Bad) | 7.8 (Good) | 4.5 (Bad) | 54.1 (Bad) | 84 (Bad) |
| | 9 | 100 | 90 | 33 | 0.40 (Good) | 0.10 (Bad) | 8.1 (Bad) | 4.3 (Bad) | 42.3 (Bad) | 30 (Good) |
| | 10 | 100 | 120 | 38 | 0.35 (Bad) | 0.15 (Bad) | 7.5 (Good) | 4.1 (Bad) | 59.8 (Bad) | 22 (Good) |
| | 11 | 100 | 85 | 30 | 0.35 (Bad) | 0.15 (Bad) | 9.1 (Bad) | 4.2 (Bad) | 59.8 (Bad) | 52 (Bad) |

| | | | | | | | | | | |
|---|---|---|---|---|---|---|---|---|---|---|
| * Reference Example | | | | | | | | | | |

**TABLE 10**

| | | SB(°C) | PEB (°C) | Sensitivity (mJ/cm²) | Dense line depth of focus | Exposure latitude | LWR | MEEF | Cross-sectional pattern shape | Development defects |
|---|---|---|---|---|---|---|---|---|---|---|
| Example | 20* | 80 | 100 | 28.9 | Good | Good | Good | Good | Good | - |
| | 21* | 80 | 100 | 26.8 | Good | Good | Good | Good | Good | - |
| | 22* | 80 | 100 | 27.5 | Good | - | Good | Good | - | Good |
| | 23* | 80 | 100 | 25.5 | Good | - | Good | Good | - | Good |
| | 24* | 80 | 100 | 28 | Good | - | Good | Good | - | Good |
| | 25* | 80 | 100 | 27.3 | Good | - | Good | Good | - | Good |

| | | | | | | | | | | |
|---|---|---|---|---|---|---|---|---|---|---|
| * Reference Example | | | | | | | | | | |

### (Examples 26 and 27 and Comparative Examples 12 and 13)

Radiation-sensitive resin compositions (Examples 26 and 27 and Comparative Examples 12 and 13) were obtained in the same manner as in Example 1, except for changing the components as shown in Table 11.

**TABLE 11**

| | | Resin (parts) | Acid generator (parts) | Acid diffusion controller (parts) | Solvent (parts) |
|---|---|---|---|---|---|
| Example | 26 | A-7 (100) | B-6 (3.8) | C-1 (0.4) | D-1 (660), D-2 (280), D-3 (40) |
| | 27 | A-10 (100) | B-6 (3.8) | C-1 (0.4) | D-1 (660), D-2 (280), D-3 (40) |
| Comparative Example | 12 | A-18 (100) | B-6 (3.8) | C-5 (0.6) | D-1 (660), D-2 (280), D-3 (40) |
| | 13 | A-21 (100) | B-6 (3.8) | C-5 (0.6) | D-1 (660), D-2 (280), D-3 (40) |

### [Evaluation methods]

The sensitivity, the dense line depth of focus, and the minimum CD of the radiation-sensitive resin compositions obtained in Examples 26 and 27 and Comparative Examples 12 and 13 were evaluated using a KrF excimer laser as a light source. The evaluation results are shown in Table 12.

### (1) Sensitivity (mJ/cm²)

An underlayer antireflective film-forming material ("DUV42P" manufactured by Brewer Science, Inc.) was applied to the surface of an 8-inch wafer to a thickness of 60 nm to form a film. The radiation-sensitive resin composition of each example and comparative example was spin-coated onto the surface of the substrate, and soft-baked (SB) for 90 seconds on a hot plate at a temperature shown in Table 12 to form a resist film having a thickness of 335 nm. The resist film was exposed via a mask pattern using a full-field reduction projection aligner ("PASS5500/750", manufactured by ASML, numerical aperture: 0.70, exposure wavelength: 248 nm).

After performing PEB for 90 seconds at a temperature shown in Table 12, the resist film was developed at 25°C for 60 seconds using a 2.38 mass% TMAH aqueous solution, washed with water, and dried to form a positive-tone resist pattern. An optimum dose (mJ/cm²) at which a 1:1 line-and-space (1L/1S) pattern having a line width of 130 nm was formed via a 1:1 line-and-space mask having a line width of 130 nm was taken as the sensitivity. The measurement was performed using the above scanning electron microscope.

### (2) Dense line depth of focus (µm)

A focus amplitude when pattern size resolved at the optimum dose using a 130 nm 1L/1S mask pattern were within ±10% of the design size of the mask was taken as the dense line depth of focus. The pattern size was measured using the above scanning electron microscope. A case where the dense line depth of focus was 0.70 µm or more was evaluated as "Good", and a case where the dense line depth of focus was less than 0.70 µm was evaluated as "Bad".

### (3) Minimum resolvable size (nm)

The minimum size of a 130 nm 1L/1S pattern resolved at the optimum dose was measured using the above scanning electron microscope. The minimum line width thus measured was taken as the minimum resolvable size, and used as an index of the resolution. A case where the minimum CD was 110 nm or less was evaluated as "Good", and a case where the minimum CD was more than 110 nm was evaluated as "Bad".

**TABLE 12**

| | | SB (°C) | PEB (°C) | Sensitivity (mJ/cm²) | Dense line depth of focus (µm) | Minimum CD (nm) |
|---|---|---|---|---|---|---|
| Example | 26 | 100 | 110 | 40 | 0.75 (Good) | 110 (Good) |
| | 27 | 100 | 100 | 45 | 0.80 (Good) | 110 (Good) |
| Comparative Example | 12 | 100 | 110 | 41 | 0.60 (Bad) | 120 (Bad) |
| | 13 | 100 | 100 | 44 | 0.65 (Bad) | 120 (Bad) |

### INDUSTRIAL APPLICABILITY

The radiation-sensitive resin composition according to one embodiment of the invention may suitably be used as a lithographic material when using a KrF excimer laser or an ArF excimer laser as a light source. The radiation-sensitive resin composition may also be used for liquid immersion lithography.

## Claims

1. A radiation-sensitive resin composition comprising (A) a polymer, (B) a photoacid generator, and (C) an acid diffusion controller, the polymer (A) including a repeating unit (a-1) shown by the following general formula (a-1) or (a-1f), and the acid diffusion controller (C) including at least one base selected from (C-1) a base shown by the following general formula (C-1) and (C-2) a photodegradable base, 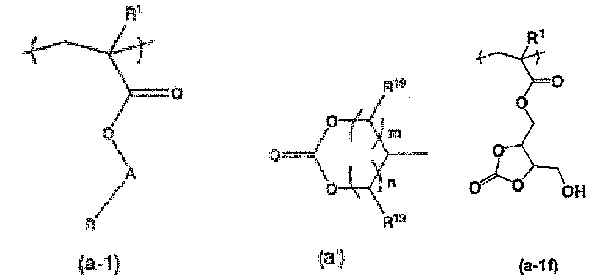 wherein R¹ individually represent a hydrogen atom, a methyl group, or a trifluoromethyl group, R represents a monovalent group shown by the above general formula (a'), R¹⁹ individually represent a hydrogen atom or a chain-like hydrocarbon group having 1 to 5 carbon atoms, A represents a single bond, a divalent chain-like hydrocarbon group having 1 to 30 carbon atoms, a divalent alicyclic hydrocarbon group having 3 to 30 carbon atoms, or a divalent aromatic hydrocarbon group having 6 to 30 carbon atoms, and m and n are integers from 0 to 3 and m + n is 1 to 3, provided that the cyclic carbonate shown by the general formula (a') may be bonded to A via a second bond in addition to a first bond shown by the general formula (a-1), and may form a ring structure including the first bond and the second bond, 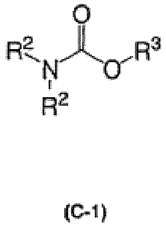 wherein R² and R³ individually represent a hydrogen atom, a monovalent chain-like hydrocarbon group having 1 to 20 carbon atoms, a monovalent alicyclic hydrocarbon group having 3 to 20 carbon atoms, or a monovalent aromatic hydrocarbon group having 6 to 20 carbon atoms, provided that the two R² may bond to form a ring structure, and
wherein the polymer (A) includes a repeating unit (a-2) including a lactone structure in addition to the repeating unit (a-1).

2. The radiation-sensitive resin composition according to claim 1, wherein the polymer (A) includes at least one repeating unit selected from a repeating unit in which a first carbon atom of the cyclic carbonate is bonded to A via the first bond, and a second carbon atom differing from the first carbon atom is bonded to A via the second bond, so that a condensed ring is formed to include the first carbon atom and the second carbon atom, and a repeating unit in which a first carbon atom of the cyclic carbonate is bonded to A via the first bond and the second bond, so that a spiro ring is formed to include the first carbon atom as a spiro atom.

3. The radiation-sensitive resin composition according to claim 1, wherein the repeating unit (a-1) is selected from the following repeating units (a-1a), (a-1c) to (a-1l), and (a-1n) to (a-1q).

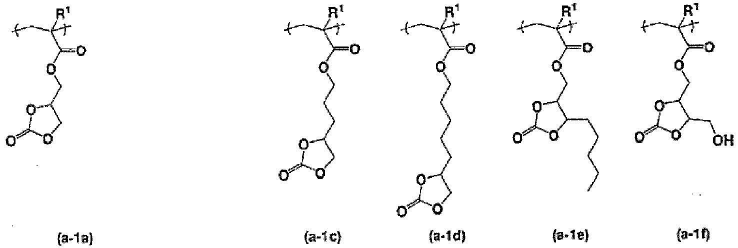

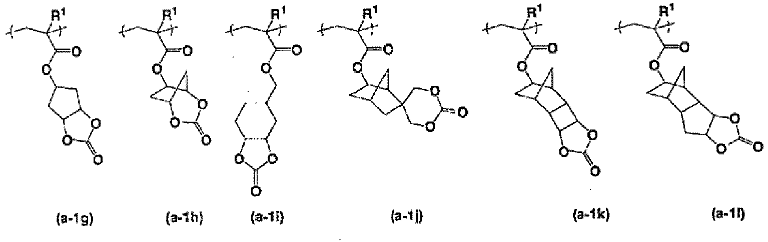

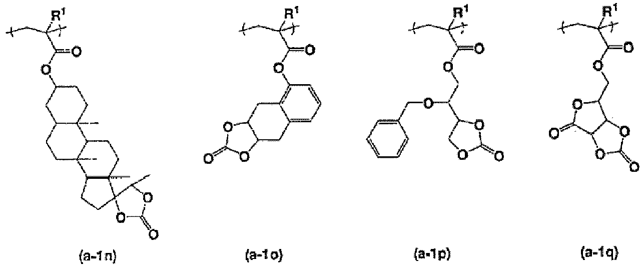

4. A polymer comprising a repeating unit (a-1) shown by the following general formula (a-1), a repeating unit (a-2) including a lactone structure in addition to the repeating unit (a-1), and a repeating unit (a-3) shown by the following general formula (a-3) in addition to the repeating unit (a-1), 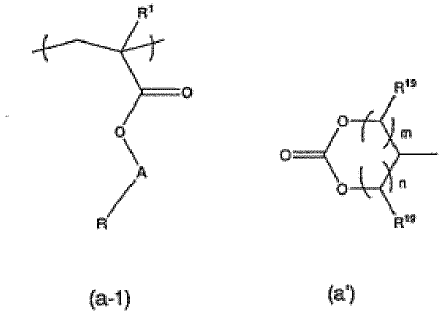 wherein R¹ individually represent a hydrogen atom, a methyl group, or a trifluoromethyl group, R represents a monovalent group shown by the above general formula (a'), R¹⁹ individually represent a hydrogen atom or a chain-like hydrocarbon group having 1 to 5 carbon atoms, A represents a single bond, a divalent chain-like hydrocarbon group having 1 to 30 carbon atoms, a divalent alicyclic hydrocarbon group having 3 to 30 carbon atoms, or a divalent aromatic hydrocarbon group having 6 to 30 carbon atoms, and m and n are integers from 0 to 3 and m + n is 1 to 3, provided that the cyclic carbonate shown by the general formula (a') may be bonded to A via a second bond in addition to a first bond shown by the general formula (a-1), and may form a ring structure including the first bond and the second bond, 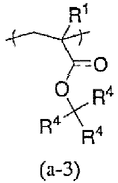 wherein R¹ individually represent a hydrogen atom, a methyl group, or a trifluoromethyl group, and R⁴ individually represent an alkyl group having 1 to 20 carbon atoms or an alicyclic hydrocarbon group having 3 to 20 carbon atoms, or two of R⁴ bond to form an alicyclic structure having 3 to 20 carbon atoms, and the remaining R⁴ represents an alkyl group having 1 to 10 carbon atoms.

5. The polymer according to claim 4 comprising at least one repeating unit selected from a repeating unit (a-3a) shown by the following general formula (a-3a) and a repeating unit (a-3b) shown by the following general formula (a-3b), 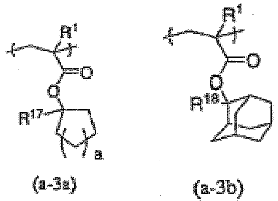 wherein R¹ individually represent a hydrogen atom, a methyl group, or a trifluoromethyl group, R¹⁷ represents an alkyl group having 1 to 10 carbon atoms, R¹⁸ represents an alkyl group having 2 to 4 carbon atoms, and a is an integer from 1 to 6.

6. The polymer according to claim 5, comprising the repeating unit (a-3a).

## Patentansprüche

1. Strahlungsempfindliche Harzzusammensetzung umfassend (A) ein Polymer, (B) einen Fotosäureerzeuger und (C) ein Säurediffusion-Kontroller, das Polymer (A) beinhaltend eine durch die folgende allgemeine Formel (a-1) oder (a-1f) gezeigte sich wiederholende Einheit (a-1), und der Säurediffusions-Kontroller (C) beinhaltend zumindest eine Base, ausgewählt aus (C-1) einer durch die folgende allgemeine Formel (C-1) gezeigten Base und (C-2) einer fotoabbaubaren Base, 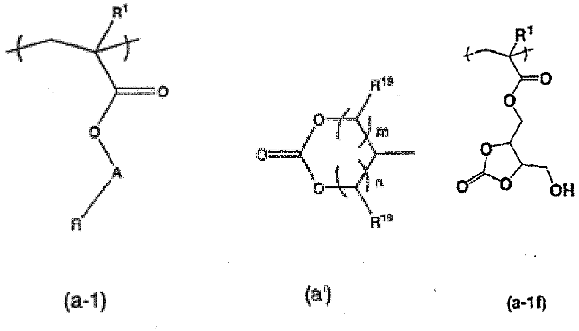 wobei R¹ einzeln ein Wasserstoffatom, eine Methylgruppe, oder eine Triflouromethylgruppe darstellt, R eine durch die vorstehende allgemeine Formel (a') gezeigte monovalente Gruppe darstellt, R¹⁹ einzeln ein Wasserstoffatom oder eine kettenartige Kohlenwasserstoffgruppe mit 1 bis 5 Kohlenstoffatomen darstellt, A eine Einzelbindung, eine bivalente kettenartige Kohlenwasserstoffgruppe mit 1 bis 30 Kohlenstoffatomen, eine bivalente alizyklische Kohlenwasserstoffgruppe mit 3 bis 30 Kohlenstoffatomen oder eine bivalente aromatische Kohlenwasserstoffgruppe mit 6 bis 30 Kohlenstoffatomen darstellt, und m und n ganze Zahlen von 0 bis 3 sind und m + n 1 bis 3 ist, vorausgesetzt, dass das durch die allgemeine Formel (a') gezeigte zyklische Carbonat an A über eine zweite Bindung zusätzlich zu einer ersten durch die allgemeine Formel (a-1) gezeigten Bindung gebunden sein kann, und eine die erste Bindung und die zweite Bindung beinhaltende Ringstruktur bilden kann, 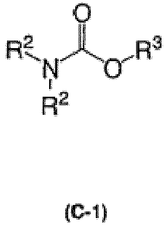 wobei R² und R³ einzeln ein Wasserstoffatom, eine monovalente kettenartige Kohlenwasserstoffgruppe mit 1 bis 20 Kohlenstoffatomen, eine monovalente alizyklische Kohlenwasserstoffgruppe mit 3 bis 20 Kohlenstoffatomen oder eine monovalente aromatische Kohlenwasserstoffgruppe mit 6 bis 20 Kohlenstoffatomen darstellen, vorausgesetzt, dass die zwei R² gebunden sein können, um eine Ringstruktur zu formen, und
wobei das Polymer (A) eine eine Lactonstruktur zusätzlich zu der sich wiederholenden Einheit (a-1) beinhaltende sich wiederholende Einheit (a-2) beinhaltet.

2. Strahlungsempfindliche Harzzusammensetzung nach Anspruch 1, wobei das Polymer (A) beinhaltet zumindest eine sich wiederholende Einheit, ausgewählt aus einer sich wiederholenden Einheit, in welcher ein erstes Kohlenstoffatom eines zyklischen Carbonats an A via der ersten Bindung gebunden ist, und ein sich von dem ersten Kohlenstoffatom unterscheidendes zweites Kohlenstoffatom an A via der zweiten Bindung gebunden ist, sodass ein kondensierter Ring gebildet ist, um das erste Kohlenstoffatom und das zweite Kohlenstoffatom zu beinhalten, und eine sich wiederholende Einheit, in welcher ein erstes Kohlenstoffatom des zyklischen Carbonats an A via der ersten Bindung und der zweiten Bindung gebunden ist, sodass ein Spiroring gebildet ist, um das erste Kohlenstoffatom als ein Spiroatom zu beinhalten.

3. Strahlungsempfindliche Harzzusammensetzung nach Anspruch 1, wobei die sich wiederholende Einheit (a-1) ausgewählt ist aus den folgenden sich wiederholenden Einheiten (a-1a), (a-1c) bis (a-1l), und (a-1n) bis (a-1q).

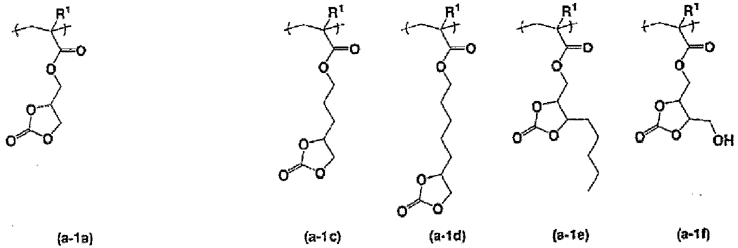

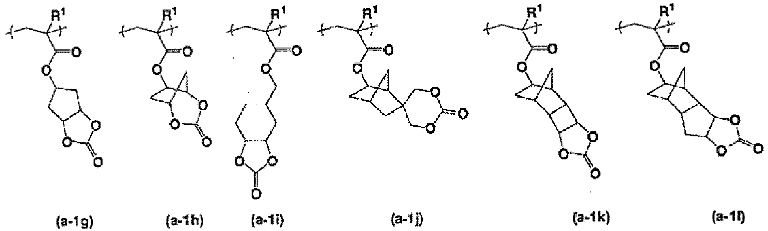

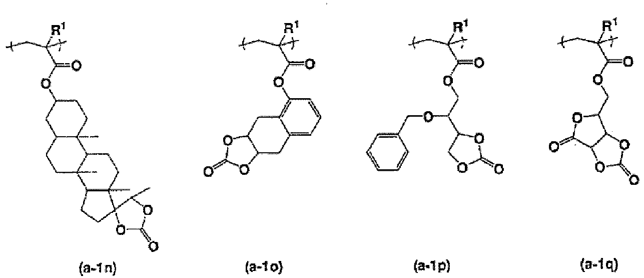

4. Polymer umfassend eine durch die folgende allgemeine Formel (a-1) gezeigte sich wiederholende Einheit (a-1), eine eine Lactonstruktur zusätzlich zu der sich wiederholenden Einheit (a-1) beinhaltende sich wiederholende Einheit (a-2), und eine durch die folgende allgemeine Formel (a-3) gezeigte sich wiederholende Einheit (a-3) zusätzlich zu der sich wiederholenden Einheit (a-1), 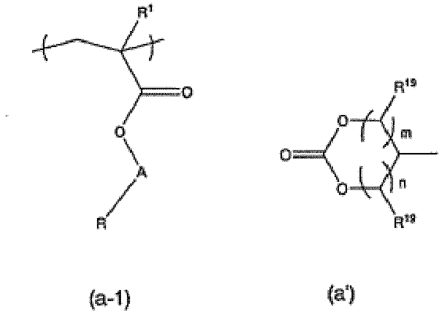 wobei R¹ einzeln ein Wasserstoffatom, eine Methylgruppe, oder eine Trifluoromethylgruppe darstellt, R eine durch die vorstehende allgemeine Formel (a') gezeigte monovalente Gruppe darstellt, R¹⁹ einzeln ein Wasserstoffatom oder eine kettenartige Kohlenwasserstoffgruppe mit 1 bis 5 Kohlenstoffatomen darstellt, A eine einzelne Bindung, eine bivalente kettenartige Kohlenwasserstoffgruppe mit 1 bis 30 Kohlenstoffatomen, eine bivalente alizyklische Kohlenwasserstoffgruppe mit 3 bis 30 Kohlenstoffatomen oder eine bivalente aromatische Kohlenwasserstoffgruppe mit 6 bis 30 Kohlenstoffatomen darstellt, und m und n ganze Zahlen von 0 bis 3 sind und m + n 1 bis 3 ist, vorausgesetzt, dass das durch die allgemeine Formel (a') gezeigte zyklische Carbonat an A via einer zweiten Bindung zusätzlich zu einer durch die allgemeine Formel (a-1) gezeigten ersten Bindung gebunden sein kann, und eine die erste Bindung und die zweite Bindung beinhaltende Ringstruktur bilden kann, 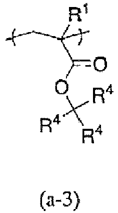 wobei R¹ einzeln ein Wasserstoffatom, eine Methylgruppe oder eine Trifluoromethylgruppe darstellt, und R⁴ einzeln eine Alkylgruppe mit 1 bis 20 Kohlenstoffatomen oder eine alizyklische Kohlenwasserstoffgruppe mit 3 bis 20 Kohlenstoffatomen darstellt oder zwei von R⁴ binden, um eine alizyklische Struktur mit 3 bis 20 Kohlenstoffatomen zu bilden, und die verbleibenden R⁴ eine Alkylgruppe mit 1 bis 10 Kohlenstoffatomen darstellen.

5. Polymer nach Anspruch 4 umfassend zumindest eine sich wiederholende Einheit, ausgewählt aus einer durch die folgende allgemeine Formel (a-3a) gezeigten sich wiederholenden Einheit (a-3a) und eine durch die folgende allgemeine Formel (a-3b) gezeigten sich wiederholende Einheit (a-3b), 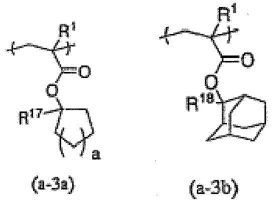 wobei R¹ einzeln ein Wasserstoffatom, eine Methylgruppe oder eine Trifluoromethlygruppe darstellt, R¹⁷ eine Alkylgruppe mit 1 bis 10 Kohlenstoffatomen darstellt, R¹⁸ eine Alkylgruppe mit 2 bis 4 Kohlenstoffatomen darstellt, und a eine ganze Zahl von 1 bis 6 ist.

6. Polymer nach Anspruch 5 umfassend die sich wiederholende Einheit (a-3a).

## Revendications

1. Composition de résine sensible aux rayonnements comprenant (A) un polymère, (B) un photogénérateur d'acide, et (C) un contrôleur de diffusion d'acide, le polymère (A) comprenant un motif de répétition (a-1) représenté par la formule générale (a-1) ou (a-1f) suivante, et le contrôleur de diffusion d'acide (C) comprenant au moins une base choisie parmi (C-1) une base représentée par la formule générale (C-1) suivante et (C-2) une base photodégradable, 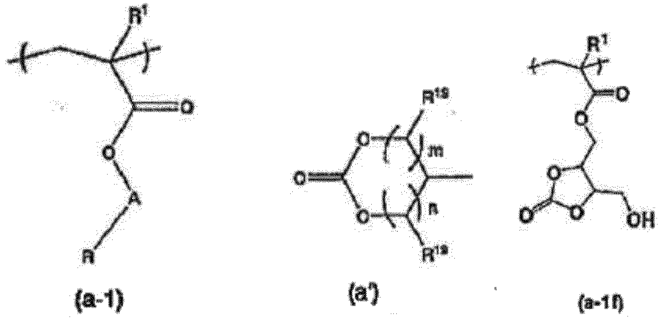 dans lesquelles les R¹ représentent individuellement un atome d'hydrogène, un groupe méthyle ou un groupe trifluorométhyle, R représente un groupe monovalent représenté par la formule générale (a') ci-dessus, les R¹⁹ représentent individuellement un atome d'hydrogène ou un groupe hydrocarboné de type chaîne ayant 1 à 5 atomes de carbone, A représente une simple liaison, un groupe hydrocarboné divalent de type chaîne ayant 1 à 30 atomes de carbone, un groupe hydrocarboné alicyclique divalent ayant 3 à 30 atomes de carbone, ou un groupe hydrocarboné aromatique divalent ayant 6 à 30 atomes de carbone, et m et n sont des nombres entiers de 0 à 3 et m + n est 1 à 3, à condition que le carbonate cyclique représenté par la formule générale (a') puisse être lié à A par l'intermédiaire d'une deuxième liaison en plus d'une première liaison représentée par la formule générale (a-1), et puisse former une structure cyclique comprenant la première liaison et la deuxième liaison, 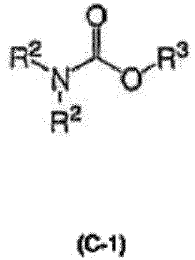 dans laquelle R² et R³ représentent individuellement un atome d'hydrogène, un groupe hydrocarboné monovalent de type chaîne ayant 1 à 20 atomes de carbone, un groupe hydrocarboné monovalent alicyclique ayant 3 à 20 atomes de carbone, ou un groupe hydrocarboné monovalent aromatique ayant 6 à 20 atomes de carbone, à condition que les deux R² puissent se lier pour former une structure cyclique, et
dans laquelle le polymère (A) comprend un motif de répétition (a-2) comprenant une structure lactone en plus du motif de répétition (a-1).

2. Composition de résine sensible aux rayonnements selon la revendication 1, dans laquelle le polymère (A) comprend au moins un motif de répétition choisi parmi un motif de répétition dans lequel un premier atome de carbone du carbonate cyclique est lié à A par l'intermédiaire de la première liaison, et un deuxième atome de carbone différant du premier atome de carbone est lié à A par l'intermédiaire de la deuxième liaison, de sorte qu'un cycle condensé est formé pour inclure le premier atome de carbone et le deuxième atome de carbone, et un motif de répétition dans lequel un premier atome de carbone du carbonate cyclique est lié à A par l'intermédiaire de la première liaison et de la deuxième liaison, de sorte qu'un cycle spiro est formé pour inclure le premier atome de carbone sous la forme d'un atome spiro.

3. Composition de résine sensible aux rayonnements selon la revendication 1, dans laquelle le motif de répétition (a-1) est choisi parmi les motifs de répétition (a-1a), (a-1c) à (a-1l), et (a-1n) à (a-1q) suivants.

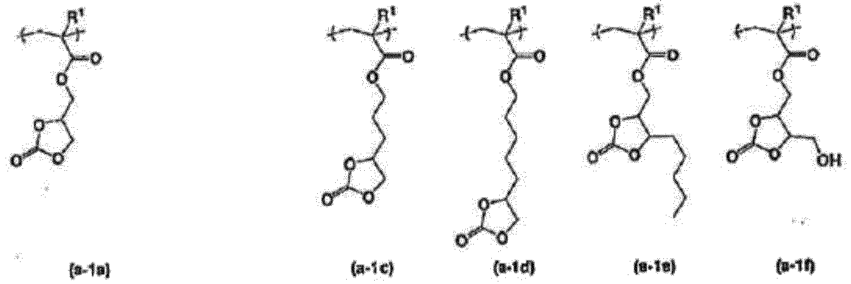

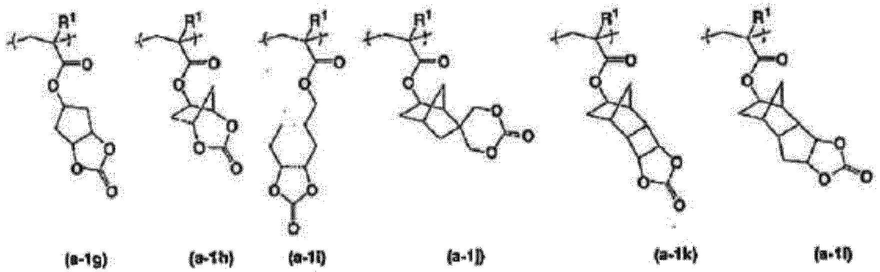

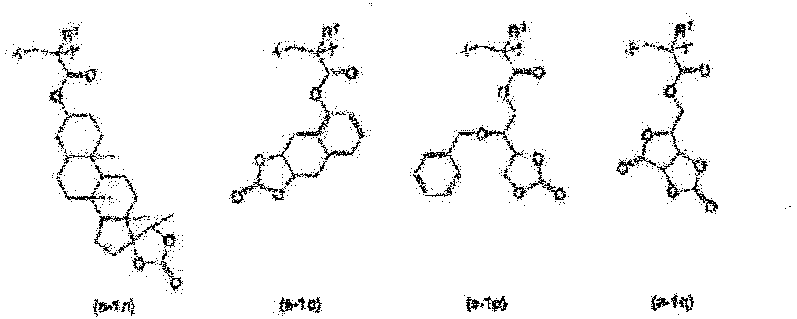

4. Polymère comprenant un motif de répétition (a-1) représenté par la formule générale (a-1) suivante, un motif de répétition (a-2) comprenant une structure lactone en plus du motif de répétition (a-1), et un motif de répétition (a-3) représenté par la formule générale (a-3) suivante en plus du motif de répétition (a-1), 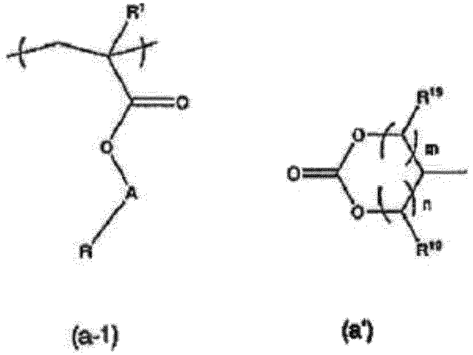 dans laquelle les R¹ représentent individuellement un atome d'hydrogène, un groupe méthyle ou un groupe trifluorométhyle, R représente un groupe monovalent représenté par la formule générale (a') ci-dessus, les R¹⁹ représentent individuellement un atome d'hydrogène ou un groupe hydrocarboné de type chaîne ayant 1 à 5 atomes de carbone, A représente une simple liaison, un groupe hydrocarboné divalent de type chaîne ayant 1 à 30 atomes de carbone, un groupe hydrocarboné divalent alicyclique ayant 3 à 30 atomes de carbone, ou un groupe hydrocarboné divalent aromatique ayant 6 à 30 atomes de carbone, et m et n sont des nombres entiers de 0 à 3 et m + n est 1 à 3, à condition que le carbonate cyclique représenté par la formule générale (a') puisse être lié à A par l'intermédiaire d'une deuxième liaison en plus d'une première liaison représentée par la formule générale (a-1), et puisse former une structure cyclique comprenant la première liaison et la deuxième liaison, 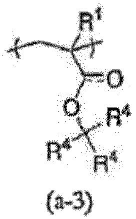 dans laquelle les R¹ représentent individuellement un atome d'hydrogène, un groupe méthyle ou un groupe trifluorométhyle, et les R⁴ représentent individuellement un groupe alkyle ayant 1 à 20 atomes de carbone ou un groupe hydrocarboné alicyclique ayant 3 à 20 atomes de carbone, ou deux des R4 se lient pour former une structure alicyclique ayant 3 à 20 atomes de carbone, et le R⁴ restant représente un groupe alkyle ayant 1 à 10 atomes de carbone.

5. Polymère selon la revendication 4, comprenant au moins un motif de répétition choisi parmi un motif de répétition (a-3a) représenté par la formule générale (a-3a) suivante et un motif de répétition (a-3b) représenté par la formule générale (a-3b) suivante, 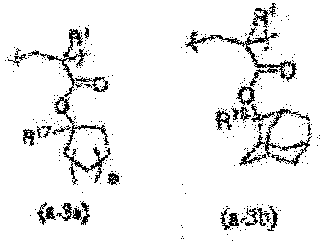 dans lesquelles les R¹ représentent individuellement un atome d'hydrogène, un groupe méthyle ou un groupe trifluorométhyle, R¹⁷ représente un groupe alkyle ayant 1 à 10 atomes de carbone, R¹⁸ représente un groupe alkyle ayant 2 à 4 atomes de carbone, et a est un nombre entier de 1 à 6.

6. Polymère selon la revendication 5, comprenant le motif de répétition (a-3a).
